# EUROPEAN PATENT SPECIFICATION

(11) **EP 3 933 914 B1**
(45) Date of publication and mention of the grant of the patent: **27.11.2024**
(21) Application number: 20926350.8
(22) Date of filing: 16.04.2020
(51) Int. Cl.: H01L 23/488, H01L 21/60, H01L 25/16, H01L 23/00

(54) **PACKAGING STRUCTURE, ELECTRIC VEHICLE AND ELECTRONIC DEVICE**
VERPACKUNGSSTRUKTUR, ELEKTRISCHES FAHRZEUG UND ELEKTRONISCHES GERÄT
STRUCTURE DE MISE EN BOÎTIER, VÉHICULE ÉLECTRIQUE ET DISPOSITIF ÉLECTRONIQUE

(43) Date of publication of application: 05.01.2022
(60) Divisional application: 24204632.4
(73) Proprietor: Huawei Digital Power Technologies Co., Ltd., Shenzhen, 518043 (CN)
(72) Inventor: LANG, Fengqun, Shenzhen, Guangdong 518129 (CN); LIN, Kaiwen, Shenzhen, Guangdong 518129 (CN)
(74) Representative: Körber, Martin Hans
(86) International application number: PCT/CN2020/085092
(87) International publication number: WO 2021/208006

(56) References cited:
- CN-A- 104 103 599
- CN-A- 104 701 188
- CN-A- 104 882 433
- CN-A- 107 785 690
- CN-A- 109 755 208
- CN-A- 109 755 266
- JP-A- 2014 060 341
- US-A1- 2006 057 817
- US-A1- 2016 113 107
- US-A1- 2019 341 332

## Description

### TECHNICAL FIELD

This application relates to the field of semiconductor technologies, and in particular, to a packaging structure, and an electric vehicle.

### BACKGROUND

With continuous development of science and technology, electronic apparatuses are developing toward high integration and high density. Currently, electronic apparatuses are often manufactured through soldering, sintering, and/or the like.

The soldering manner is used as an example. In a manufacturing process of the electronic apparatus, a solder layer needs to have a flat surface, and should not be subjected to shape bending caused by impact of another interference factor, so that parallelism of the solder layer can meet a process requirement. In addition, a thickness of the solder layer needs to meet a manufacturing requirement. The thickness cannot be excessively small to avoid affecting reliability of the electronic apparatus and shortening a service life of the electronic apparatus. In addition, the thickness cannot be excessively large to avoid a poor heat dissipation effect of the electronic apparatus that is caused by an increase in a thermal resistance of the electronic apparatus.

In addition, a plurality of times of reflow are required in the manufacturing process of the electronic apparatus. Therefore, available types of solders are limited, and the solder very likely needs to be remelted. Consequently, quality of the solder layer is deteriorated, and electrical short-circuiting and a failure of the electronic apparatus are caused.

Therefore, how to control thicknesses or a thickness and warpage of the solder layer and/or a sintering layer to determine reliability of the electronic apparatus is a problem that currently urgently needs to be resolved.

US 2016/0113107 A1 discloses a power module including a substrate, a power chip, a bonding material, and at least one spacer. The substrate includes a circuit-patterned layer. The power chip is bonded to the circuit-patterned layer by the bonding material, and the spacer is located between the circuit-patterned layer and the power chip.

### SUMMARY

This application provides a packaging structureand an electronic apparatus, to improve reliability of the packaging structure, the electric vehicle, and the electronic apparatus and reduce manufacturing costs of the packaging structure, the electric vehicle, and the electronic apparatus. The invention is defined in the independent claims. Additional features of the invention are provided in the dependent claims. In the following, parts of the description and drawings referring to embodiments which are not covered by the claims are not presented as embodiments of the invention, but as examples useful for understanding the invention.

According to a first aspect, this application provides a packaging structure, including a first substrate, a first bonding layer, an electronic element, a second bonding layer, and a second substrate. The first bonding layer is located between a first conductive surface of the first substrate and a first bonding surface of the electronic element, and the first bonding layer is configured to implement bonding between the electronic element and the first substrate. The first bonding layer includes a first bonding material and at least one first support part, a height of the at least one first support part is the same as a thickness of the first bonding layer, and a melting point of the at least one first support part is higher than a maximum temperature at which the first bonding layer is formed, so that the first bonding layer has a flat surface and a uniform thickness. The second bonding layer is located between a second bonding surface of the electronic element and a first conductive surface of the second substrate, the second bonding layer is configured to implement bonding between the electronic element and the second substrate, and the first bonding surface of the electronic element is opposite to the second bonding surface of the electronic element.

According to the packaging structure provided in the first aspect, in a process of forming the first bonding layer, the at least one first support part does not completely dissolve in the first bonding material, so that the thickness of the at least one first support part remains the same as the thickness of the first bonding layer, and the first bonding layer with the height of the at least one first support part is formed by using the at least one first support part. In addition, when a plurality of times of reflow are required for the packaging structure, the at least one first support part does not move with movement of the first bonding material, so that the at least one first support part is evenly distributed in the first bonding layer, and based on a support function of the at least one first support part, the first bonding layer can withstand extrusion without deformation, and the first bonding material does not overflow even if the at least one first support part is remelted, thereby ensuring good quality and bonding strength of the first bonding layer, and avoiding a phenomenon such as electrical short-circuiting or a failure of the electronic element that is caused by insufficiency of the first bonding material below the electronic element. In this way, it is ensured that the first bonding layer has a flat surface and a uniform thickness, and process requirements for the thickness and warpage of the first bonding layer are met. In addition, unlimited types of the first bonding material facilitate manufacturing of the first bonding layer, and reduce costs of the first bonding layer. Therefore, reliability of the packaging structure is improved, manufacturing costs of the packaging structure are reduced, and competitiveness of the packaging structure is improved.

In a possible design, the second bonding layer includes a second bonding material and at least one second support part, a height of the at least one second support part is the same as a thickness of the second bonding layer, and a melting point of the at least one second support part is higher than a maximum temperature at which the second bonding layer is formed, so that the second bonding layer has a flat surface and a uniform thickness.

In a process of forming the second bonding layer, the at least one second support part does not completely dissolve in the second bonding material in the second bonding layer, so that the thickness of the at least one second support part remains the same as the thickness of the second bonding layer, and the second bonding layer with the height of the at least one second support part is formed by using the at least one second support part. In addition, when a plurality of times of reflow are required for the packaging structure, the at least one second support part does not move with movement of the second bonding material, so that the at least one second support part is evenly distributed in the second bonding layer, and based on a support function of the at least one second support part, the second bonding layer can withstand extrusion without deformation, and the second bonding material in the second bonding layer does not overflow even if the at least one second support part is remelted, thereby ensuring good quality and bonding strength of the second bonding layer, and avoiding a phenomenon such as electrical short-circuiting or a failure of the electronic element that is caused by insufficiency of the second bonding material below the second substrate. In this way, it is ensured that the second bonding layer has a flat surface and a uniform thickness, and process requirements for the thickness and warpage of the second bonding layer are met. In addition, unlimited types of the second bonding material in the second bonding layer facilitate manufacturing of the second bonding layer, and reduce costs of the second bonding layer.

Therefore, based on the flat surface and the uniform thickness of the second bonding layer, a good bonding effect and an electrical connection are implemented between the first conductive surface of the second substrate and the second bonding surface of the electronic element by using the second bonding layer, and bonding costs are further reduced.

In conclusion, the first bonding layer and the second bonding layer are disposed, so that the first conductive surface of the first substrate, the first bonding layer, the electronic element, the second bonding layer, and the first conductive surface of the second substrate are securely bonded and reliably connected. This improves reliability of the packaging structure, reduces bonding costs of the packaging structure, and improves competitiveness of the packaging structure.

In a possible design, to prevent the second support part from being melted by the second bonding material and prevent a solder from moving to the outside of the second bonding layer during bonding, the second support part may be fastening. Optionally, the at least one second support part is fastening on the second bonding surface of the electronic element or the first conductive surface of the second substrate. Therefore, the operation is convenient and quick, generation efficiency is high, and a position of the second support part in the second bonding layer is flexible, so that a second support part of a required size is implanted at a required position.

In a possible design, the second support part has a micrometer-scale size. A size of the second support part in each dimension is at a micrometer scale. Therefore, compared with a volume of the second bonding layer with a size of several millimeters, the size of the second support part is quite small, so that the second support part has quite small impact on a process of the second bonding layer during bonding, and does not prevent a bubble formed on the second bonding layer from escaping from the second bonding material. This avoids an excessively high void rate of the second bonding layer, and therefore does not adversely affect reliability of the second bonding layer.

In a possible design, the packaging structure further includes a plastic packaging material; and the first substrate, the first bonding layer, a part of the electronic element, the second bonding layer, and the second substrate are all disposed in the plastic packaging material. Therefore, each component and an electrical connection between the components in the packaging structure are protected by using the plastic packaging material, and this facilitates use of the packaging structure.

In a possible design, to prevent the first support part from being melted by the first bonding material and prevent a solder from moving to the outside of the first bonding layer during bonding, the first support part may be fastening. Optionally, the at least one first support part is fastening on the first bonding surface of the electronic element or the first conductive surface of the first substrate. Therefore, the operation is convenient and quick, generation efficiency is high, and a position of the first support part in the first bonding layer is flexible, so that a first support part of a required size is implanted at a required position.

In a possible design, the first support part has a micrometer-scale size. A size of the first support part in each dimension is at a micrometer scale. Therefore, compared with a volume of the first bonding layer with a size of several millimeters, the size of the first support part is quite small, so that the first support part has quite small impact on a process of the first bonding layer during bonding, and does not prevent a bubble formed on the first bonding layer from escaping from the first bonding material. This avoids an excessively high void rate of the first bonding layer, and therefore does not adversely affect reliability and a thermal conductivity of the first bonding layer.

In a possible design, if a plurality of unconnected first bonding layers and a plurality of unconnected second bonding layers are included, the electronic element includes a chip, a third bonding layer, an interconnection column, a signal terminal, and a power terminal. The chip is located between a first bonding layer other than a first bonding layer corresponding to the signal terminal and a first bonding layer corresponding to the power terminal and the third bonding layer, and the interconnection column is located between a third bonding layer corresponding to the chip and a corresponding second bonding layer. The signal terminal is disposed extending from the inside of the packaging structure to the outside of the packaging structure, an end of the signal terminal that is located inside the packaging structure is located on a first bonding layer other than a first bonding layer corresponding to the chip and the first bonding layer corresponding to the power terminal, the first bonding layer includes a first bonding material and a first support part that is fastening on the first conductive surface of the first substrate, the signal terminal is electrically connected to the chip, and the first bonding layer corresponding to the chip and the first bonding layer corresponding to the signal terminal correspond to different conductive areas in the first conductive surface of the first substrate. The power terminal is disposed extending from the inside of the packaging structure to the outside of the packaging structure, an end of the power terminal that is located inside the packaging structure is located on a first bonding layer other than the first bonding layer corresponding to the chip and the first bonding layer corresponding to the signal terminal, the first bonding layer includes a first bonding material and a first support part that is fastening on the first conductive surface of the first substrate, and the first bonding layer corresponding to the chip and the first bonding layer corresponding to the power terminal correspond to a same conductive area in the first conductive surface of the first substrate; and/or the power terminal is located on a second bonding layer other than a second bonding layer corresponding to the interconnection column, the second bonding layer includes a second bonding material and a second support part that is fastening on the first conductive surface of the second substrate, and the second bonding layer corresponding to the interconnection column and a second bonding layer corresponding to the power terminal correspond to a same conductive area in the first conductive surface of the second substrate. The third bonding layer includes a third bonding material and at least one third support part, a height of the at least one third support part is the same as a thickness of the third bonding layer, and a melting point of the at least one third support part is higher than a maximum temperature at which the third bonding layer is formed, so that the third bonding layer has a flat surface and a uniform thickness.

In a process of forming the third bonding layer, the at least one third support part does not completely dissolve in the third bonding material in the third bonding layer, so that the thickness of the at least one third support part remains the same as the thickness of the third bonding layer, and the third bonding layer with the height of the at least one third support part is formed by using the at least one third support part. In addition, when a plurality of times of reflow are required for the packaging structure, the at least one third support part does not move with movement of the third bonding material, so that the at least one third support part is evenly distributed in the third bonding layer, and based on a support function of the at least one third support part, the third bonding layer can withstand extrusion without deformation, and the third bonding material in the third bonding layer does not overflow even if the at least one third support part is remelted, thereby ensuring good quality and bonding strength of the third bonding layer, and avoiding a phenomenon such as electrical short-circuiting or a failure of the chip that is caused by insufficiency of the third bonding material below the interconnection column. In this way, it is ensured that the third bonding layer has a flat surface and a uniform thickness, and process requirements for the thickness and warpage of the third bonding layer are met. In addition, unlimited types of the third bonding material in the third bonding layer facilitate manufacturing of the third bonding layer, and reduce costs of the third bonding layer.

Therefore, based on the flat surface and the uniform thickness of the third bonding layer, a good bonding effect and an electrical connection are implemented between the chip and the interconnection column by using the third bonding layer, and bonding costs are further reduced.

In conclusion, the first bonding layer, the second bonding layer, and the third bonding layer are disposed, so that the first conductive surface of the first substrate, the first bonding layer, the chip, the third bonding layer, the interconnection column, the second bonding layer, and the first conductive surface of the second substrate are securely bonded and reliably connected, the signal terminal and the first conductive surface of the first substrate are securely bonded and reliably connected, and the power terminal and the first conductive surface of the first substrate and/or the first conductive surface of the second substrate are securely bonded and reliably connected. This improves reliability of the packaging structure, and reduces bonding costs of the packaging structure. The packaging structure can further implement a complete power conversion process.

In a possible design, to prevent the third support part from being melted by the third bonding material and prevent a solder from moving to the outside of the third bonding layer during bonding, the third support part may be fastening. Optionally, the at least one third support part is fastening on a side that is of the chip and that is close to the interconnection column or a side that is of the interconnection column and that is close to the chip. Therefore, the operation is convenient and quick, generation efficiency is high, and a position of the third support part in the third bonding layer is flexible, so that a third support part of a required size is implanted at a required position.

In a possible design, the third support part has a micrometer-scale size. A size of the third support part in each dimension is at a micrometer scale. Therefore, compared with a volume of the third bonding layer with a size of several millimeters, the size of the third support part is quite small, so that the third support part has quite small impact on a process of the third bonding layer during bonding, and does not prevent a bubble formed on the third bonding layer from escaping from the third bonding material. This avoids an excessively high void rate of the third bonding layer, and therefore does not adversely affect reliability of the third bonding layer.

In a possible design, if a plurality of unconnected first bonding layers and a plurality of unconnected second bonding layers are included, the electronic element includes a chip, a signal terminal, and a power terminal. The chip is located between a first bonding layer other than a first bonding layer corresponding to the signal terminal and a first bonding layer corresponding to the power terminal and a corresponding second bonding layer. The signal terminal is disposed extending from the inside of the packaging structure to the outside of the packaging structure, an end of the signal terminal that is located inside the packaging structure is located on a first bonding layer other than a first bonding layer corresponding to the chip and the first bonding layer corresponding to the power terminal, the first bonding layer includes a first bonding material and a first support part that is fastening on the first conductive surface of the first substrate, the signal terminal is electrically connected to the chip, and the first bonding layer corresponding to the chip and the first bonding layer corresponding to the signal terminal correspond to different conductive areas in the first conductive surface of the first substrate. The power terminal is disposed extending from the inside of the packaging structure to the outside of the packaging structure, an end of the power terminal that is located inside the packaging structure is located on a first bonding layer other than the first bonding layer corresponding to the chip and the first bonding layer corresponding to the signal terminal, the first bonding layer includes a first bonding material and a first support part that is fastening on the first conductive surface of the first substrate, and the first bonding layer corresponding to the chip and the first bonding layer corresponding to the power terminal correspond to a same conductive area in the first conductive surface of the first substrate; and/or the power terminal is located on a second bonding layer other than a second bonding layer corresponding to the chip, the second bonding layer includes a second bonding material and a second support part that is fastening on the first conductive surface of the second substrate, and the second bonding layer corresponding to the chip and a second bonding layer corresponding to the power terminal correspond to a same conductive area in the first conductive surface of the second substrate.

In conclusion, the first bonding layer, the second bonding layer, and the third bonding layer are disposed, so that the first conductive surface of the first substrate, the first bonding layer, the chip, the second bonding layer, and the first conductive surface of the second substrate are securely bonded and reliably connected, the signal terminal and the first conductive surface of the first substrate are securely bonded and reliably connected, and the power terminal and the first conductive surface of the first substrate and/or the first conductive surface of the second substrate are securely bonded and reliably connected. This improves reliability of the packaging structure, and reduces bonding costs of the packaging structure. The packaging structure can further implement a complete power conversion process.

In a possible design, the electronic element further includes a sensor. Both ends of the sensor are separately located on first bonding layers other than the first bonding layer corresponding to the chip, the first bonding layer corresponding to the signal terminal, and the first bonding layer corresponding to the power terminal, the first bonding layer includes a first bonding material and a first support part that is fastening on the first conductive surface of the first substrate, and the first bonding layer corresponding to the chip and the two first bonding layers corresponding to the sensor correspond to different conductive areas in the first conductive surface of the first substrate; and/or one end of the sensor is located on a first bonding layer other than the first bonding layer corresponding to the chip, the first bonding layer corresponding to the signal terminal, and the first bonding layer corresponding to the power terminal, the other end of the sensor is disposed extending from the inside of the packaging structure to the outside of the packaging structure through a transmission wire, and the first bonding layer corresponding to the chip and the first bonding layer corresponding to the sensor correspond to different conductive areas in the first conductive surface of the first substrate.

In a possible design, the packaging structure further includes a first heat dissipation part and a fourth bonding layer. The fourth bonding layer is located between a second conductive surface of the first substrate and the first heat dissipation part, the second conductive surface of the first substrate is exposed to the outside of the packaging structure, and the fourth bonding layer is configured to implement bonding between the first substrate and the first heat dissipation part. The fourth bonding layer includes a fourth bonding material and at least one fourth support part, a height of the at least one fourth support part is the same as a thickness of the fourth bonding layer, and a melting point of the at least one fourth support part is higher than a maximum temperature at which the fourth bonding layer is formed, so that the fourth bonding layer has a flat surface and a uniform thickness.

In a process of forming the fourth bonding layer, the at least one fourth support part does not completely dissolve in the fourth bonding material in the fourth bonding layer, so that the thickness of the at least one fourth support part remains the same as the thickness of the fourth bonding layer, and the fourth bonding layer with the height of the at least one fourth support part is formed by using the at least one fourth support part. In addition, when a plurality of times of reflow are required for the packaging structure, the at least one fourth support part does not move with movement of the fourth bonding material, so that the at least one fourth support part is evenly distributed in the fourth bonding layer, and based on a support function of the at least one fourth support part, the fourth bonding layer can withstand extrusion without deformation, and the fourth bonding material in the fourth bonding layer does not overflow even if the at least one fourth support part is remelted, thereby ensuring good quality and bonding strength of the fourth bonding layer. In this way, it is ensured that the fourth bonding layer has a flat surface and a uniform thickness, and process requirements for the thickness and warpage of the fourth bonding layer are met. In addition, unlimited types of the fourth bonding material in the fourth bonding layer facilitate manufacturing of the fourth bonding layer, and reduce costs of the fourth bonding layer are reduced.

Therefore, based on the flat surface and the uniform thickness of the fourth bonding layer, a good bonding effect is implemented between the first substrate and the first heat dissipation part by using the fourth bonding layer, so that reliability and a cooling capability of the packaging structure are improved, and bonding costs are further reduced, thereby facilitating high density and high integration of the packaging structure.

In a possible design, to prevent the fourth support part from being melted by the fourth bonding material and prevent a solder from moving to the outside of the fourth bonding layer during bonding, the fourth support part may be fastening. Optionally, the at least one fourth support part is fastening on the second conductive surface of the first substrate or a side that is of the first heat dissipation part and that is close to the first substrate. Therefore, the operation is convenient and quick, generation efficiency is high, and a position of the fourth support part in the fourth bonding layer is flexible, so that a fourth support part of a required size is implanted at a required position.

In a possible design, the fourth support part has a micrometer-scale size. A size of the fourth support part in each dimension is at a micrometer scale. Therefore, compared with a volume of the fourth bonding layer with a size of several millimeters, the size of the fourth support part is quite small, so that the fourth support part has quite small impact on a process of the fourth bonding layer during bonding, and does not prevent a bubble formed on the fourth bonding layer from escaping from the fourth bonding material. This avoids an excessively high void rate of the fourth bonding layer, and therefore does not adversely affect reliability of the fourth bonding layer.

In a possible design, the packaging structure further includes a second heat dissipation part and a fifth bonding layer. The fifth bonding layer is located between a second conductive surface of the second substrate and the second heat dissipation part, the second conductive surface of the second substrate is exposed to the outside of the packaging structure, and the fifth bonding layer is configured to implement bonding between the second substrate and the second heat dissipation part. The fifth bonding layer includes a fifth bonding material and at least one fifth support part, a height of the at least one fifth support part is the same as a thickness of the fifth bonding layer, and a melting point of the at least one fifth support part is higher than a maximum temperature at which the fifth bonding layer is formed, so that the fifth bonding layer has a flat surface and a uniform thickness.

In a possible design, to prevent the fifth support part from being melted by the fifth bonding material and prevent a solder from moving to the outside of the fifth bonding layer during bonding, the fifth support part may be fastening. Optionally, the at least one fifth support part is fastening on the second conductive surface of the second substrate or a side that is of the second heat dissipation part and that is close to the second substrate. Therefore, the operation is convenient and quick, generation efficiency is high, and a position of the fifth support part in the fifth bonding layer is flexible, so that a fifth support part of a required size is implanted at a required position.

In a possible design, the fifth support part has a micrometer-scale size. A size of the fifth support part in each dimension is at a micrometer scale. Therefore, compared with a volume of the fifth bonding layer with a size of several millimeters, the size of the fifth support part is quite small, so that the fifth support part has quite small impact on a process of the fifth bonding layer during bonding, and does not prevent a bubble formed on the fifth bonding layer from escaping from the fifth bonding material. This avoids an excessively high void rate of the fifth bonding layer, and therefore does not adversely affect reliability of the fifth bonding layer.

In a possible design, the support part may be set to a micrometer-scale size, so that impact on bonding of the bonding layer is small, thereby avoiding a reduction of a bonding effect of the bonding layer that is caused by an excessively large size of the support part and improving reliability of the bonding layer. A size of the support part in each dimension is at a micrometer scale. Therefore, compared with a volume of the bonding layer with a size of several millimeters, the size of the support part is quite small, so that the support part has quite small impact on a process of the bonding layer during bonding, and does not prevent a bubble formed on the bonding layer from escaping from the bonding material. This avoids an excessively high void rate of the bonding layer, and therefore does not adversely affect reliability of the bonding layer. In a possible design, support parts in different bonding layers have a same shape or different shapes; and/or a plurality of support parts in a same bonding layer have a same shape or different shapes.

In a possible design, a shape of the support part includes at least one of a spherical shape, a rectangular shape, an ellipsoid shape, a wedge shape, or a silkworm shape.

In a possible design, support parts in different bonding layers have a same material or different materials; and/or a plurality of support parts in a same bonding layer have a same material or different materials.

In a possible design, the support part is any one of a single-metal material, an alloy material, a composite material, or a non-conductive material. Therefore, manufacturing costs of the packaging structure are reduced.

In a possible design, the support part is any one of a covering material, a coating material, a strip material, and a wire material. Therefore, a plurality of possibilities are provided for the bonding layer.

In a possible design, support parts in different bonding layers have a same height or different heights.

In a possible design, there is a same quantity or different quantities of support parts in different bonding layers. Therefore, a quantity of support parts in the bonding layer is adjustable. Generally, the quantity of support parts may be greater than or equal to 3, to further improve a bonding effect of the bonding layer and ensure a support balance of a bonded part.

In a possible design, the support part is fastening in any one of the following manners: an ultrasonic wave, sintering, electroplating, or brazing.

In a possible design, when a type of the bonding layer includes a solder layer, the bonding material includes a soldering lug or solder paste; and/or when the type of the bonding layer is a sintering layer, the bonding material includes a powdered material or a paste material.

According to a second aspect, this application provides an electric vehicle, including a power supply battery, a motor control unit MCU, and Q motors, where Q is a positive integer. The motor control unit MCU includes 3R packaging structures according to the first aspect and any possible design of the first aspect, R is a positive integer, the power supply battery provides first electric energy for each packaging structure, and each motor is correspondingly connected to at least three packaging structures. For any one of the 3R packaging structures, the motor control unit MCU is configured to: control the packaging structure to convert the first electric energy into second electric energy required by a motor correspondingly connected to the packaging structure, and control the packaging structure to transmit the second electric energy to the motor correspondingly connected to the packaging structure.

For beneficial effects of the electric vehicle provided in the second aspect and the possible designs of the second aspect, refer to the beneficial effects brought by the first aspect and the possible implementations of the first aspect. Details are not described herein again.

According to a third aspect, this application provides an electronic apparatus, including at least one bonded structure, where the at least one bonded structure includes a bonded part and at least one support part of a micrometer-scale size. The at least one support part is disposed on at least one to-be-bonded surface of the bonded part. For a support part on any to-be-bonded surface of the bonded part, a height of the support part is the same as a thickness of a bonding layer, the support part and a bonding material form the bonding layer, and a melting point of the support part is higher than a maximum temperature at which the bonding layer is formed, so that the bonding layer has a flat surface and a uniform thickness.

In a possible design, the electronic apparatus includes a three-dimensional 3D packaging module.

According to the electronic apparatus provided in the third aspect, in a bonding process of the bonded part, because the support part of the micrometer-scale size is disposed on the to-be-bonded surface of the bonded part, the height of the support part is the same as the thickness of the bonding layer, and the melting point of the support part is higher than the maximum temperature at which the bonding layer is formed, the support part does not completely dissolve in the bonding material in the bonding layer, so that the thickness of the support part remains the same as the thickness of the bonding layer, and the bonding layer with the same height as the support part is formed by using the support part. In addition, when a plurality of times of reflow are required for the electronic apparatus, the support part does not move with movement of the bonding material, so that the support part is evenly distributed in the bonding layer, and based on a support function of the support part, the bonding layer can withstand extrusion without deformation, and the bonding material in the bonding layer does not overflow even if the support part is remelted, thereby ensuring good quality and bonding strength of the bonding layer, and avoiding a phenomenon such as electrical short-circuiting or a failure of the electronic apparatus that is caused by insufficiency of the bonding material below the bonded part. In this way, it is ensured that the bonding layer has a flat surface and a uniform thickness, and process requirements for the thickness and warpage of the bonding layer are met. In addition, unlimited types of the bonding material in the bonding layer facilitate manufacturing of the bonding layer, and reduce manufacturing costs of the bonding layer. Therefore, reliability of the electronic apparatus is improved, and manufacturing costs of the electronic apparatus are reduced.

### BRIEF DESCRIPTION OF DRAWINGS

FIG. 1 is a schematic cross-sectional diagram of a high-density semiconductor apparatus;
FIG. 2 is a schematic diagram of a structure of a packaging structure according to an embodiment of this application;
FIG. 3 is a schematic diagram of a structure in which a support part is fastening on an electronic element according to an embodiment of this application;
FIG. 4 is a schematic diagram of an X-ray for a case in which an electronic element is bonded to a first substrate according to an embodiment of this application;
FIG. 5 is a schematic flowchart in which a support part is fastening on an electronic element according to an embodiment of this application;
FIG. 6 is a schematic flowchart in which a support part is fastening on an electronic element according to an embodiment of this application;
FIG. 7 is a schematic diagram of a manufacturing procedure of a packaging structure according to an embodiment of this application;
FIG. 8 is a schematic diagram of a manufacturing procedure of a packaging structure according to an embodiment of this application;
FIG. 9 is a schematic diagram of a structure of a packaging structure according to an embodiment of this application;
FIG. 10 is a schematic diagram of a structure of a packaging structure according to an embodiment of this application;
FIG. 11 is a schematic diagram of a structure of a packaging structure according to an embodiment of this application;
FIG. 12 is a schematic diagram of a position of a sensor in a packaging structure according to an embodiment of this application;
FIG. 13 is a schematic diagram of a position of a sensor in a packaging structure according to an embodiment of this application;
FIG. 14 is a schematic diagram of a structure of a packaging structure according to an embodiment of this application;
FIG. 15 is a schematic diagram of a structure of a packaging structure according to an embodiment of this application;
FIG. 16 is a schematic diagram of a structure of a packaging structure according to an embodiment of this application;
FIG. 17 is a schematic diagram of a structure of a packaging structure according to an embodiment of this application; and
FIG. 18 is a schematic diagram of a structure of an electric vehicle according to an embodiment of this application.

### Reference numerals:

200: High-density semiconductor apparatus; 201: First copper-bonded insulating substrate; 202: IGBT; 203: FRD; 204: Interconnection column a'; 205: Interconnection column b'; 206: Signal terminal a; 207: First power terminal; 208: Second copper-bonded insulating substrate; 209: Second power terminal; 210: Plastic packaging material;
100: Packaging structure; 101: First substrate; 102: First bonding layer; 102a: First support part; 102b: First bonding material; 103: Electronic element; 104: Second bonding layer; 104a: Second support part; 104b: Second bonding material; 105: Second substrate; 106: Plastic packaging material; 103a: Chip; 103b: Third bonding layer; 103c: Interconnection column; 103d: Signal terminal; 103e: Power terminal; 103ba: Third support part; 103bb: Third bonding material; 107: Sensor; 108: First heat dissipation part; 109: Fourth bonding layer; 110: Second heat dissipation part; 111: Fifth bonding layer; 109a: Fourth support part; 109b: Fourth bonding material; 111a: Fifth support part; 111b: Fifth bonding material; 100': DCAC conversion module;
300: Ultrasonic wave bonding head; 400: Ultrasonic wave bonding head and cutter; 500: Positioning plate; 601: Fixture; 602: Thickness control ring; 102a': First tiny metal block; 104a': Second tiny metal block;
1: Electric vehicle; 11: Power supply battery; 12: Motor control unit MCU; 13: Motor.

### DESCRIPTION OF EMBODIMENTS

Electronic apparatuses are developing toward high integration and high density. Electronic apparatuses are often manufactured through soldering, sintering, and/or the like. The soldering manner is used as an example. To ensure reliability of the electronic apparatus, there are requirements for a thickness, parallelism, and warpage of a solder layer, to meet requirements of processes such as aluminum wire bonding and bonding of components in the electronic apparatus.

Generally, in a manufacturing process of the electronic apparatus, a plurality of times of reflow are required, and solders of different melting points need to be used. A melting point of a solder used in a current reflow process usually needs to be higher than a melting point of a solder used in a next reflow process, to avoid a case that in the next reflow process, the solder used in the current reflow process is remelted to cause displacement of a bonded body, and therefore quality of a solder layer is deteriorated, a bonding effect of the solder layer is poor, a phenomenon of electrical short-circuiting or a failure of the electronic apparatus is prone to occur, and reliability of the electronic apparatus is seriously affected.

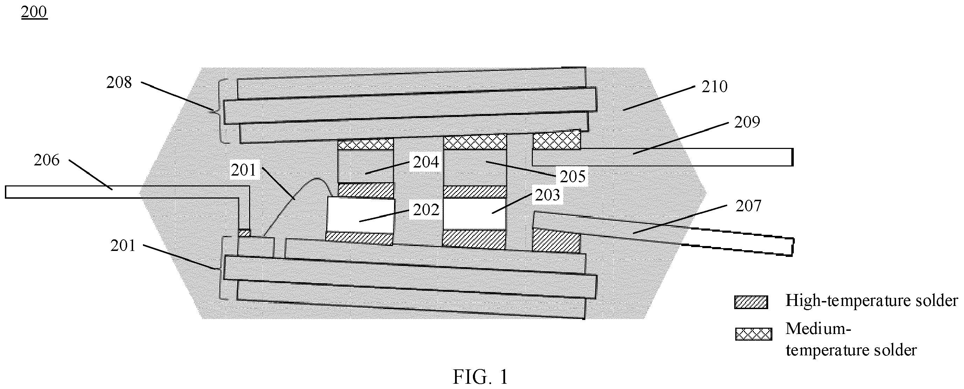

With reference to FIG. 1, the following describes an example in which an electronic apparatus is a high-density semiconductor apparatus 200. In FIG. 1, a high-temperature solder is illustrated in a left-slash grid, and a medium-temperature solder is illustrated in a cross-line grid.

First, as shown in FIG. 1, four high-temperature solders are separately used to solder a bottom surface of an insulated bipolar transistor (insulated bipolar transistor, IGBT) 202 to a first copper-bonded insulating substrate 201, a bottom surface of a fast recovery diode (FRD for short) 203 to the first copper-bonded insulating substrate 201, a bottom surface of an interconnection column a' 204 to a top surface of the IGBT 202, and a bottom surface of an interconnection column b' 205 to a top surface of the FRD 203. In addition, two high-temperature solders may be further separately used to solder both ends of a resistor (not illustrated in FIG. 1) to the first copper-bonded insulating substrate 201, one high-temperature solder is used to solder one end of a signal terminal a 206 in FIG. 1 to the first copper-bonded insulating substrate 201, and one high-temperature solder is used to solder one end of a first power terminal 207 in FIG. 1 to the first copper-bonded insulating substrate 201.

Moreover, further with reference to FIG. 1, two medium-temperature solders are separately used to solder a second copper-bonded insulating substrate 208 to a top surface of the interconnection column a' 204 and a top surface of the interconnection column b' 205. In addition, a medium-temperature solder may be further used to solder one end of a second power terminal 209 to the second copper-bonded insulating substrate 208.

Next, further with reference to FIG. 1, two low-temperature solders (not illustrated in FIG. 1) are separately used to solder a lower heat dissipation part to a bottom surface of the first copper-bonded insulating substrate 201 in FIG. 1 and an upper heat dissipation part to a top surface of the second copper-bonded insulating substrate 208 in FIG. 1. It should be noted that this step is an optional step.

Finally, further with reference to FIG. 1, a plastic packaging material 210 is used to implement plastic packaging of the foregoing structure, to complete manufacturing the high-density semiconductor apparatus 200.

Based on the foregoing description, an operating temperature of the high-density semiconductor apparatus 200 is limited to a lowest melting point of a solder in the foregoing process, that is, a melting point of the medium-temperature solder or a melting point of the low-temperature solder in FIG. 1. Currently, for a high-temperature solder, available solders are a lead high-temperature solder, a lead-free high-temperature solder (for example, gold-germanium Au-Ge, gold-silicon Au-Si, gold-tin Au-Sn, aluminum-zinc Al-Zn, tin-antimony Sn-Sb, and bismuth-silver Bi-Ag), and the like. For a medium-temperature solder, available solders are tin-copper Sn-Cu, a tin paste SAC305 solder (melting point: 217°C), and the like. For a low-temperature solder, available solders are tin-bismuth Sn-Bi (melting point: 139°C), tin-indium Sn-In (melting point: 118°C), and the like.

However, there is usually a lead-free requirement in a manufacturing process of the high-density semiconductor apparatus 200, and therefore use of lead high-temperature solders is limited to meet specifications of RoHS. In addition, a high price of gold-based high-temperature solders limits widespread application of the gold-based high-temperature solders. An excessively low thermal conductivity (approximately 10 W/km) of the bismuth-silver Bi-Ag solder needs to be overcome. Corrosion and wettability of the aluminum-zinc Al-Zn solder need to be overcome. A melting point of the tin-antimony Sn-Sb alloy solder is slightly low (243 degrees centigrade). Melting points of other solders are also relatively low. Therefore, types of solders that can be used in the manufacturing process of the high-density semiconductor apparatus 200 are limited. In addition, the solder is also likely to be melted due to a plurality of times of reflow.

In conclusion, due to limitations of available types of solders and a remelting risk of the solder, an amount of polishing after plastic packaging is excessively large because parallelism of the two copper-bonded insulating substrates is excessively large, it is difficult to plug the high-density semiconductor apparatus 200 to other electrical components because parallelism of terminals is poor, solder overflow is caused because quality of a solder layer of a bonded body such as a chip or a terminal is poor, and further a phenomenon such as electrical short-circuiting or a failure of the high-density semiconductor apparatus 200 is caused by insufficiency of a solder below the bonded body.

To resolve the foregoing problem, this application provides a packaging structure, an electric vehicle, and an electronic apparatus. By fixedly disposing a support part on a bonded part, a bonding layer with a flat surface and a uniform thickness is implemented through a support function, a thickness maintaining function, and a warpage maintaining function of the support part, so that a thickness and warpage of the bonding layer meet process requirements, types of a bonding material in the bonding layer are not limited, manufacturing costs of the bonding layer are reduced, and overflow of the bonding material in the bonding layer is avoided, and insufficiency of the bonding material below the bonding part is avoided. This ensures that an electrical connection between the packaging structure, the electric vehicle, and the electronic apparatus is convenient and secure, improves reliability of the packaging structure, the electric vehicle, and the electronic apparatus, and improves competitiveness of the packaging structure, the electric vehicle, and the electronic apparatus.

The following describes in detail specific implementations of a packaging structure 100 in this application with reference to specific embodiments.

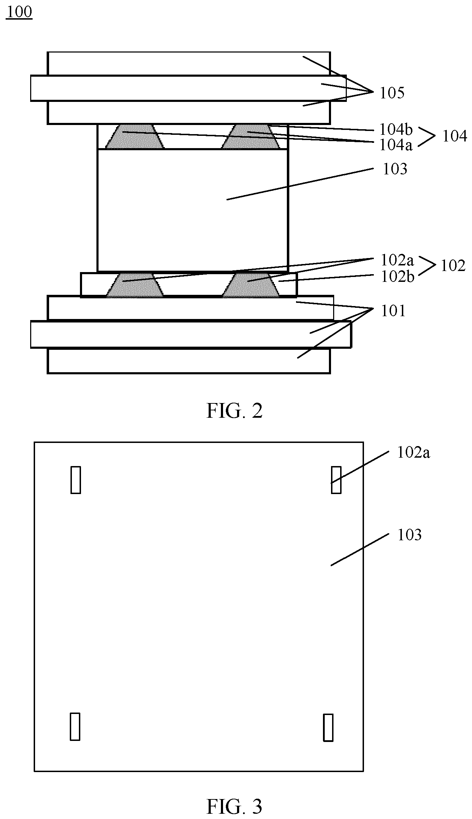

FIG. 2 is a schematic diagram of a structure of a packaging structure according to an embodiment of this application. As shown in FIG. 2, the packaging structure 100 provided in this application may include a first substrate 101, a first bonding layer 102, an electronic element 103, a second bonding layer 104, and a second substrate 105. For ease of description, one first bonding layer 102 and one second bonding layer 104 are used for illustration in FIG. 2.

In this application, the first bonding layer 102 is located between a first conductive surface of the first substrate 101 and a first bonding surface of the electronic element 103, and the first bonding layer 102 is configured to implement bonding between the electronic element 103 and the first substrate 101.

The electronic element 103 may include one component or may include a plurality of components. All the plurality of components may be connected, or all the plurality of components may not be connected, or some of the plurality of components are connected and the other components are not connected.

There may be one or more first bonding layers 102, and a quantity of first bonding layers 102 may be specifically set based on an electrical connection status of a component in the electronic element 103. Generally, one component corresponds to one first bonding layer 102. In addition, one component may alternatively correspond to a plurality of first bonding layers 102. This is not limited in this application.

In this application, the first substrate 101 may include a plurality of implementations.

In a feasible implementation, optionally, the first substrate 101 may include a first conductive layer and a first insulation layer. Both the first conductive layer and the first insulation layer are disposed inside the packaging structure 100, and the first conductive surface of the first substrate 101 is the first conductive layer.

The first conductive layer may use a conductive material such as copper Cu, and the first insulation layer may use an insulating material such as glass, ceramic, or epoxy resin. In addition, in this application, the first conductive layer may be disposed on a side of the first insulation layer through coating, etching, or the like.

In another feasible implementation, optionally, the first substrate 101 may include a first conductive layer, a first insulation layer, and a second conductive layer. Both the first conductive layer and the first insulation layer are disposed inside the packaging structure 100, the first conductive surface of the first substrate 101 is the first conductive layer, the first insulation layer is located between the first conductive layer and the second conductive layer, a second conductive surface of the first substrate 101 is the second conductive layer, and the second conductive layer is exposed to the outside of the packaging structure 100, to improve a heat dissipation capability of the packaging structure 100. For ease of description, in FIG. 2, the first substrate 101 is illustrated by using three rectangular frames. A rectangular frame near the electronic element 103 is the first conductive layer, a rectangular frame in the middle is the first insulation layer, and a rectangular frame away from the electronic element 103 is the second conductive layer.

The first conductive layer and the second conductive layer may use a conductive material such as copper Cu, and the first insulation layer may use an insulating material such as glass, ceramic, or epoxy resin. In addition, in this application, the first conductive layer may be disposed on one side of the first insulation layer through coating, etching, or the like, and the second conductive layer may be disposed on the other side of the first insulation layer through coating, etching, or the like.

In addition, the first conductive surface of the first substrate 101 may include one conductive area, or may include a plurality of conductive areas, and the plurality of conductive areas are not connected. Generally, any conductive area corresponds to one component, or any conductive area corresponds to a plurality of connected components.

In this application, the first bonding layer 102 may include a first bonding material 102b and at least one first support part 102a. For ease of description, one first bonding layer 102 uses two first support parts 102a for illustration in FIG. 2.

A specific type of the first bonding material 102b may be set based on a bonding manner, and is not limited in this application. Optionally, when a type of the first bonding layer 102 includes a solder layer, the first bonding material 102b may include a soldering lug or solder paste. When the type of the first bonding layer 102 includes a sintering layer, the first bonding material 102b may include a powdered material or a paste material. When the type of the first bonding layer 102 includes a solder layer and a sintering layer, the first bonding material 102b in the solder layer may include a soldering lug or solder paste, and the first bonding material 102b in the sintering layer may include a powdered material or a paste material.

The first support part 102a may be set to a micrometer-scale size, that is, a size of the first support part 102a in each dimension is at a micrometer scale. Because the size of the first support part 102a in each dimension is at a micrometer scale, compared with a volume of the first bonding layer 102 with a size of several millimeters, the size of the first support part 102a is quite small, so that the first support part 102a has quite small impact on a process of the first bonding layer 102 during bonding, and does not prevent a bubble formed on the first bonding layer 102 from escaping from the first bonding material 102b. This avoids an excessively high void ratio of the first bonding layer 102, and therefore has small impact on bonding of the first bonding layer 102, to avoid a reduction of a bonding effect between the first conductive surface of the first substrate 101 and the first bonding surface of the electronic element 103 that is caused by an excessively large size of the at least one first support part 102a, so that the first conductive surface of the first substrate 101 and the first bonding surface of the electronic element 103 can be reliably bonded.

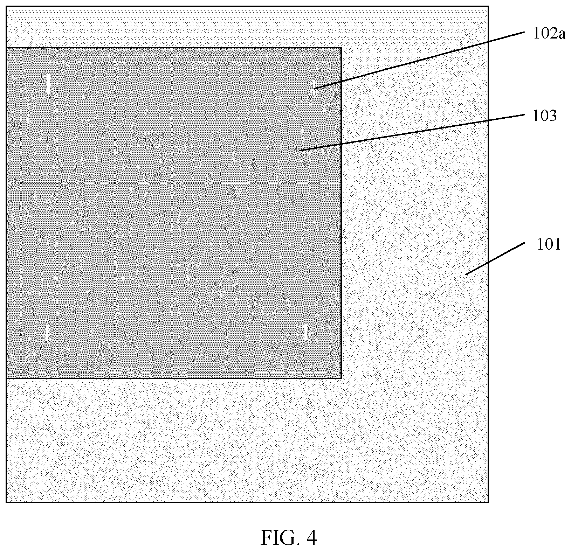

In a specific embodiment, as shown in FIG. 3, four first support parts 102a are fastening on the first bonding surface of the electronic element 103, and a height, a length, and a width of each first support part 102a are approximately 130 micrometers, 700 micrometers, and 200 micrometers, respectively. The electronic element 103 is bonded to the conductive surface of the first substrate 101, so that an X-ray (X-ray) is used to measure a void rate obtained after the electronic element 103 and the first substrate 101 are bonded. As shown in FIG. 4, the void rate meets a manufacturing process requirement, so that disposing of the first support part 102a has small impact on bonding between the electronic element 103 and the first substrate 101.

Optionally, first support parts 102a in different first bonding layers 102 may have a same shape or different shapes. A plurality of first support parts 102a in a same first bonding layer 102 may have a same shape or different shapes. A shape of the first support part 102a is not limited in this application. Optionally, the shape of the first support part 102a includes at least one of a spherical shape, a rectangular shape, an ellipsoid shape, a wedge shape, or a silkworm shape.

Optionally, first support parts 102a in different first bonding layers 102 may have a same material or different materials. A plurality of first support parts 102a in a same first bonding layer 102 may have a same material or different materials. A material of the first support part 102a is not limited in this application. Optionally, the first support part 102a is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the first support part 102a is any one of a covering material, a coating material, a strip material, and a wire material, for example, a metal coating or a heterogeneous metal covering. Therefore, manufacturing costs of the packaging structure 100 are reduced.

Optionally, there may be a same quantity or different quantities of first support parts 102a in different first bonding layers 102. A quantity of first support parts 102a in any first bonding layer 102 is not limited in this application. Therefore, the quantity of first support parts 102a in the first bonding layer 102 is adjustable. Generally, the quantity of first support parts 102a may be greater than or equal to 3, to further improve a bonding effect of the first bonding layer 102 and ensure a support balance between the first substrate 101 and the electronic element 103.

Optionally, first support part 102a in different first bonding layers 102 may have a same position or different positions. A position of a first support part 102a in any first bonding layer 102 is not limited in this application. Therefore, the position of the first support part 102a in the first bonding layer 102 is flexible, so that a first support part 102a of a required size is implanted at a required position.

In this application, to prevent the first support part 102a from being melted by the first bonding material 102b and prevent a solder from moving to the outside of the first bonding layer 102 during bonding, the first support part 102a may be fastening. Further, because the first support part 102a has small impact on bonding of the first bonding layer 102, the first support part 102a may have a plurality of disposing positions, the operation is convenient and quick, and generation efficiency is high.

Optionally, the at least one first support part 102a may be fastening on the first bonding surface of the electronic element 103.

Optionally, the at least one first support part 102a may be fastening on the first conductive surface of the first substrate 101.

Optionally, the at least one first support part 102a may be fastening on the first bonding surface of the electronic element 103 and the first conductive surface of the first substrate 101, and first support parts 102a on the first bonding surface of the electronic element 103 and first support parts 102a on the first conductive surface of the first substrate 101 are alternately disposed.

A manner of fastening the first support part 102a is not limited in this application. Optionally, the first support part 102a is fastening in any one of the following manners: an ultrasonic wave, sintering, electroplating, or brazing.

In this application, a height of the at least one first support part 102a is the same as a thickness of the first bonding layer 102, and a melting point of the at least one first support part 102a is higher than a maximum temperature at which the first bonding layer 102 is formed. The thickness of the first bonding layer 102 may be set based on an actual case, and is not limited in this application. The height of the first support part 102a may be set based on a thickness of a corresponding first bonding layer 102, and a specific value of the height of the first support part 102a is not limited. Optionally, first support parts 102a in different first bonding layers 102 may have a same height or different heights.

Based on the foregoing setting, in a process of forming the first bonding layer 102, the at least one first support part 102a does not completely dissolve in the first bonding material 102b in the first bonding layer 102, so that the thickness of the at least one first support part 102a remains the same as the thickness of the first bonding layer 102, and the first bonding layer 102 with the height of the at least one first support part 102a is formed by using the at least one first support part 102a. In addition, when a plurality of times of reflow are required for the packaging structure 100, the at least one first support part 102a does not move with movement of the first bonding material 102b, so that the at least one first support part 102a is evenly distributed in the first bonding layer 102, and based on a support function of the at least one first support part 102a, the first bonding layer 102 can withstand extrusion without deformation, and the first bonding material 102b in the first bonding layer 102 does not overflow even if the at least one first support part 102a is remelted, thereby ensuring good quality and bonding strength of the first bonding layer 102, and avoiding a phenomenon such as electrical short-circuiting or a failure of the electronic element 103 that is caused by insufficiency of the first bonding material 102b below the electronic element 103. In this way, it is ensured that the first bonding layer 102 has a flat surface and a uniform thickness, and process requirements for the thickness and warpage of the first bonding layer 102 are met. In addition, unlimited types of the first bonding material 102b in the first bonding layer 102 facilitate manufacturing of the first bonding layer 102, and reduce costs of the first bonding layer 102.

Therefore, based on the flat surface and the uniform thickness of the first bonding layer 102, a good bonding effect and an electrical connection are implemented between the first conductive surface of the first substrate 101 and the first bonding surface of the electronic element 103 by using the first bonding layer 102, and bonding costs are further reduced.

In this application, the second bonding layer 104 is located between a second bonding surface of the electronic element 103 and a first conductive surface of the second substrate 105, the second bonding layer 104 is configured to implement bonding between the electronic element 103 and the second substrate 105, and the first bonding surface of the electronic element 103 is opposite to the second bonding surface of the electronic element 103.

There may be one or more second bonding layers 104, and a quantity of second bonding layers 104 may be specifically set based on an electrical connection status of a component in the electronic element 103. Generally, one component corresponds to one second bonding layer 104. In addition, one component may alternatively correspond to a plurality of second bonding layers 104. This is not limited in this application.

In this application, the second substrate 105 may include a plurality of implementations.

In a feasible implementation, optionally, the second substrate 105 may include a third conductive layer and a second insulation layer. Both the third conductive layer and the second insulation layer are disposed inside the packaging structure 100, and the first conductive surface of the second substrate 105 is the third conductive layer.

The third conductive layer may use a conductive material such as copper Cu, and the second insulation layer may use an insulating material such as glass, ceramic, or epoxy resin. In addition, in this application, the third conductive layer may be disposed on a side of the second insulation layer through coating, etching, or the like.

In another feasible implementation, optionally, the second substrate 105 may include a third conductive layer, a second insulation layer, and a fourth conductive layer. Both the third conductive layer and the second insulation layer are disposed inside the packaging structure 100, the first conductive surface of the second substrate 105 is the third conductive layer, the second insulation layer is located between the third conductive layer and the fourth conductive layer, a second conductive surface of the second substrate 105 is the fourth conductive layer, and the fourth conductive layer is exposed to the outside of the packaging structure 100, to improve a heat dissipation capability of the packaging structure 100. For ease of description, in FIG. 2, the second substrate 105 is illustrated by using three rectangular frames. A rectangular frame near the electronic element 103 is the third conductive layer, a rectangular frame in the middle is the second insulation layer, and a rectangular frame away from the electronic element 103 is the fourth conductive layer.

The third conductive layer and the fourth conductive layer may use a conductive material such as copper Cu, and the second insulation layer may use an insulating material such as glass, ceramic, or epoxy resin. In addition, in this application, the third conductive layer may be disposed on one side of the second insulation layer through coating, etching, or the like, and the fourth conductive layer may be disposed on the other side of the second insulation layer through coating, etching, or the like.

In addition, the first conductive surface of the second substrate 105 may include one conductive area, or may include a plurality of conductive areas, and the plurality of conductive areas are not connected. Generally, any conductive area corresponds to one component, or any conductive area corresponds to a plurality of connected components.

In conclusion, the first bonding layer 102 and the second bonding layer 104 is disposed, so that the first conductive surface of the first substrate 101, the first bonding layer 102, the electronic element 103, the second bonding layer 104, and the first conductive surface of the second substrate 105 are securely bonded and reliably connected. This improves reliability of the packaging structure 100, reduces manufacturing costs of the packaging structure 100 are reduced, and improves competitiveness of the packaging structure 100.

A specific type of the packaging structure 100 is not limited in this application. For example, the packaging structure 100 may be a high-power semiconductor module such as a double-sided cooling power module (double-sided cooling power module, DSC-PM); or the packaging structure 100 may be a semiconductor module with a printed circuit board, for example, a semiconductor apparatus that has a stack structure and that needs to control a thickness of a solder layer and prevent solder overflow.

According to the packaging structure provided in this application, the first bonding layer is disposed between the first conductive surface of the first substrate and the first bonding surface of the electronic element, so that the electronic element and the electronic element are bonded based on the first bonding layer. The first bonding layer includes the first bonding material and the at least one first support part. The second bonding layer is disposed between the second bonding surface of the electronic element and the first conductive surface of the second substrate, so that the electronic element and the second substrate are bonded based on the second bonding layer. The first bonding surface of the electronic element is opposite to the second bonding surface of the electronic element. Because the height of the at least one first support part is the same as the thickness of the first bonding layer, and the melting point of the at least one first support part is higher than the maximum temperature at which the first bonding layer is formed, in the process of forming the first bonding layer, the at least one first support does not completely dissolve in the first bonding material, so that the thickness of the at least one first support part remains the same as the thickness of the first bonding layer, and the first bonding layer with the height of the at least one first support part 102a is formed by using the at least one first support part. In addition, when a plurality of times of reflow are required for the packaging structure, the at least one first support part does not move with movement of the first bonding material, so that the at least one first support part is evenly distributed in the first bonding layer, and based on the support function of the at least one first support part, the first bonding layer can withstand extrusion without deformation, and the first bonding material does not overflow even if the at least one first support part is remelted, thereby ensuring good quality and bonding strength of the first bonding layer, and avoiding a phenomenon such as electrical short-circuiting or a failure of the electronic element that is caused by insufficiency of the first bonding material below the electronic element. In this way, it is ensured that the first bonding layer has a flat surface and a uniform thickness, and process requirements for the thickness and warpage of the first bonding layer are met. In addition, unlimited types of the first bonding material facilitate manufacturing of the first bonding layer, and reduce costs of the first bonding layer. Therefore, reliability of the packaging structure is improved, manufacturing costs of the packaging structure are reduced, and competitiveness of the packaging structure is improved.

Based on the foregoing embodiments shown in FIG. 2 to FIG. 4, the following describes in detail a specific structure of each component in the packaging structure 100 in this application with reference to some specific embodiments.

Further referring to FIG. 2, in this application, the second bonding layer 104 may include a second bonding material 104b and at least one second support part 104a. For ease of description, one second bonding layer 104 uses two second support parts 104a for illustration in FIG. 2.

A specific type of the second bonding material 104b may be set based on a bonding manner, and is not limited in this application. Optionally, when a type of the second bonding layer 104 includes a solder layer, the second bonding material 104b may include a soldering lug or solder paste. When the type of the second bonding layer 104 includes a sintering layer, the second bonding material 104b may include a powdered material or a paste material. When the type of the second bonding layer 104 includes a solder layer and a sintering layer, the second bonding material 104b in the solder layer may include a soldering lug or solder paste, and the second bonding material 104b in the sintering layer may include a powdered material or a paste material.

The second support part 104a may be set to a micrometer-scale size, that is, a size of the second support part 104a in each dimension is at a micrometer scale. Because the size of the second support part 104a in each dimension is at a micrometer scale, compared with a volume of the second bonding layer 104 with a size of several millimeters, the size of the second support part 104a is quite small, so that the second support part 104a has quite small impact on a process of the second bonding layer 104 during bonding, and does not prevent a bubble formed on the second bonding layer 104 from escaping from the second bonding material 104b. This avoids an excessively high void ratio of the second bonding layer 104, and therefore has small impact on bonding of the second bonding layer 104, to avoid a reduction of a bonding effect between the first conductive surface of the second substrate 105 and the second bonding surface of the electronic element 103 that is caused by an excessively large size of the at least one second support part 104a, so that the first conductive surface of the second substrate 105 and the second bonding surface of the electronic element 103 can be reliably bonded.

Optionally, second support parts 104a in different second bonding layers 104 may have a same shape or different shapes. A plurality of second support parts 104a in a same second bonding layer 104 may have a same shape or different shapes. A shape of the second support part 104a is not limited in this application. Optionally, the shape of the second support part 104a includes at least one of a spherical shape, a rectangular shape, an ellipsoid shape, a wedge shape, or a silkworm shape.

Optionally, second support parts 104a in different second bonding layers 104 may have a same material or different materials. A plurality of second support parts 104a in a same second bonding layer 104 may have a same material or different materials. A material of the second support part 104a is not limited in this application. Optionally, the second support part 104a is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the second support part 104a is any one of a covering material, a coating material, a strip material, and a wire material, for example, a metal coating or a heterogeneous metal covering. Therefore, manufacturing costs of the packaging structure 100 are reduced.

Optionally, there may be a same quantity or different quantities of second support parts 104a in different second bonding layers 104. A quantity of second support parts 104a in any second bonding layer 104 is not limited in this application. Therefore, the quantity of second support parts 104a in the second bonding layer 104 is adjustable. Generally, the quantity of second support parts 104a may be greater than or equal to 3, to further improve a bonding effect of the second bonding layer 104 and ensure a support balance between the second substrate 105 and the electronic element 103.

Optionally, second support parts 104a in different second bonding layers 104 may have a same position or different positions. A position of a second support part 104a in any second bonding layer 104 is not limited in this application. Therefore, the position of the second support part 104a in the second bonding layer 104 is flexible, so that a second support part 104a of a required size is implanted at a required position.

In this application, to prevent the second support part 104a from being melted by the second bonding material 104b and prevent a solder from moving to the outside of the second bonding layer 104 during bonding, the second support part 104a may be fastening. Further, because the second support part 104a has small impact on bonding of the second bonding layer 104, the second support part 104a may have a plurality of disposing positions, the operation is convenient and quick, and generation efficiency is high.

Optionally, the at least one second support part 104a may be fastening on the second bonding surface of the electronic element 103.

Optionally, the at least one second support part 104a may be fastening on the first conductive surface of the second substrate 105.

Optionally, the at least one second support part 104a may be fastening on the second bonding surface of the electronic element 103 and the first conductive surface of the second substrate 105, and second support parts 104a on the second bonding surface of the electronic element 103 and second support parts 104a on the first conductive surface of the second substrate 105 are alternately disposed.

A manner of fastening the second support part 104a is not limited in this application. Optionally, the second support part 104a is fastening in any one of the following manners: an ultrasonic wave, sintering, electroplating, or brazing.

In this application, a height of the at least one second support part 104a is the same as a thickness of the second bonding layer 104, and a melting point of the at least one second support part 104a is higher than a maximum temperature at which the second bonding layer 104 is formed. The thickness of the second bonding layer 104 may be set based on an actual case, and is not limited in this application. The height of the second support part 104a may be set based on a thickness of a corresponding second bonding layer 104, and a specific value of the height of the second support part 104a is not limited. Optionally, second support parts 104a in different second bonding layers 104 may have a same height or different heights.

Based on the foregoing setting, in a process of forming the second bonding layer 104, the at least one second support part 104a does not completely dissolve in the second bonding material 104b in the second bonding layer 104, so that the thickness of the at least one second support part 104a remains the same as the thickness of the second bonding layer 104, and the second bonding layer 104 with the height of the at least one second support part 104a is formed by using the at least one second support part 104a. In addition, when a plurality of times of reflow are required for the packaging structure 100, the at least one second support part 104a does not move with movement of the second bonding material 104b, so that the at least one second support part 104a is evenly distributed in the second bonding layer 104, and based on a support function of the at least one second support part 104a, the second bonding layer 104 can withstand extrusion without deformation, and the second bonding material 104b in the second bonding layer 104 does not overflow even if the at least one second support part 104a is remelted, thereby ensuring good quality and bonding strength of the second bonding layer 104, and avoiding a phenomenon such as electrical short-circuiting or a failure of the electronic element 103 that is caused by insufficiency of the second bonding material 104b below the second substrate 105. In this way, it is ensured that the second bonding layer 104 has a flat surface and a uniform thickness, and process requirements for the thickness and warpage of the second bonding layer 104 are met. In addition, unlimited types of the second bonding material 104b in the second bonding layer 104 facilitate manufacturing of the second bonding layer 104, and reduce costs of the second bonding layer 104.

Therefore, based on the flat surface and the uniform thickness of the second bonding layer 104, a good bonding effect and an electrical connection are implemented between the first conductive surface of the second substrate 105 and the second bonding surface of the electronic element 103 by using the second bonding layer 104, and bonding costs are further reduced.

In conclusion, the first bonding layer 102 and the second bonding layer 104 are disposed, so that the first conductive surface of the first substrate 101, the first bonding layer 102, the electronic element 103, the second bonding layer 104, and the first conductive surface of the second substrate 105 are securely bonded and reliably connected. This improves reliability of the packaging structure 100, reduces bonding costs of the packaging structure 100, and improves competitiveness of the packaging structure 100.

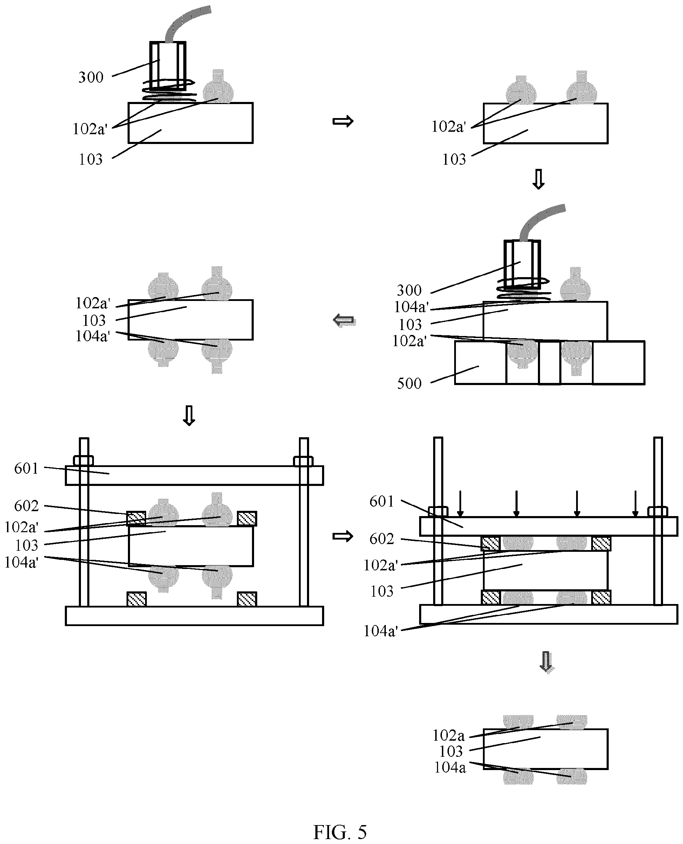

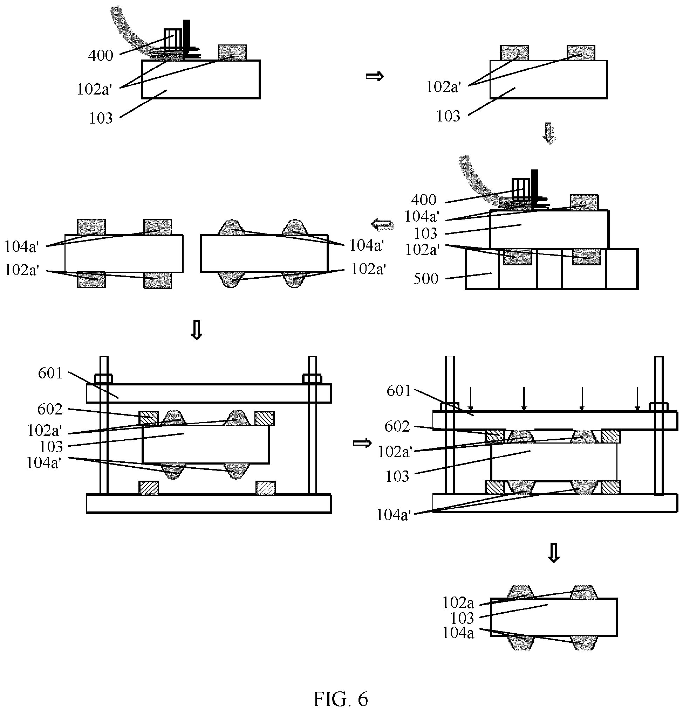

In this application, the first support part 102a may be fastened in a plurality of manners, and the second support part 104a may also be fastened in a plurality of manners. With reference to FIG. 5 to FIG. 6, the following uses examples to describe a specific implementation process in which both the first support part 102a and the second support part 104a are fastening in the electronic element 103. For ease of description, in FIG. 5, the first support part 102a and the second support part 104a are sphere-shaped, and a quantity of support parts on each of the two bonding surfaces of the electronic element 103 is set to three. In FIG. 6, the first support part 102a and the second support part 104a are silkworm-shaped, and a quantity of support parts on each of the two bonding surfaces of the electronic element 103 is set to three. In addition, because FIG. 5 and FIG. 6 are cross-sectional diagrams, FIG. 5 and FIG. 6 illustrate only two support parts on each of the two bonding surfaces of the electronic element 103.

As shown in FIG. 5, first, three first tiny metal blocks 102' (only two first tiny metal blocks 102' are illustrated in FIG. 5) are separately implanted into an upper bonding surface of the electronic element 103 by using an ultrasonic wave bonding head 300, so that the three first tiny metal blocks 102' are fastening on the upper bonding surface of the electronic element 103. A side that is of each first tiny metal block 102' and that is close to the upper bonding surface of the electronic element 103 is sphere-shaped, and a height of each first tiny metal block 102' is greater than the thickness of the first bonding layer 102. For example, the height of the first tiny metal block 102' falls between 0.02 mm and 10 mm, and the thickness of the first bonding layer 102 falls between 0.01 mm and 10 mm.

In addition, after the three first tiny metal blocks 102' are implanted into the upper bonding surface of the electronic element 103, the electronic element 103 is turned over, and the three first tiny metal blocks 102' are separately placed in three holes of a positioning plate 500, to prevent the three first tiny metal blocks 102' from hindering a subsequent ultrasonic wave operation. Then, three second tiny metal blocks 104' (only two second tiny metal blocks 104' are illustrated in FIG. 5) are separately implanted into a lower bonding surface of the electronic element 103 by using the ultrasonic wave bonding head 300, so that the three second tiny metal blocks 104' are fastening on the lower bonding surface of the electronic element 103. A side that is of each second tiny metal block 104' and that is close to the lower bonding surface of the electronic element 103 is sphere-shaped, and a height of each second tiny metal block 104' is greater than the thickness of the second bonding layer 104.

Therefore, three tiny metal blocks are fastening on each of the upper bonding surface and the lower bonding surface of the electronic element 103.

Next, the electronic element 103 with the lower bonding surface facing downwards is placed in a fixture 601, so that the three second tiny metal blocks 104' are separately placed in three holes of the fixture 601. Then, pressure is applied to the fixture 601 in a direction of an arrow shown in FIG. 5. Two thickness control rings 602 are used to perform flattening processing on the three first tiny metal blocks 102', and the other two thickness control rings 602 have a height maintaining auxiliary function to adjust heights of the three first tiny metal blocks 102', so that the heights of the three first tiny metal blocks 102' are the same as the thickness of the first bonding layer 102, and the thickness of the first bonding layer 102 is adjusted. In this way, three first support parts 102a are fastening on the upper bonding surface of the electronic element 103.

Then, after flattening processing on the three first tiny metal blocks 102' on the upper bonding surface of the electronic element 103 is completed, the electronic element 103 with the upper bonding surface facing downwards is placed in the fixture 601, so that the three first support parts 102a are separately placed in the three holes of the fixture 601. Then, pressure is applied to the fixture 601 in a direction of an arrow shown in FIG. 5. Two thickness control rings 602 are used to perform flattening processing on the three second tiny metal blocks 104', and the other two control rings 602 have a height maintaining auxiliary function to adjust heights of the three second tiny metal blocks 104', so that the heights of the three second tiny metal blocks 104' are the same as the thickness of the second bonding layer 104, and the thickness of the second bonding layer 104 is adjusted. In this way, three second support parts 104a are fastening on the lower bonding surface of the electronic element 103. It should be noted that a principle of an implementation process of this step is the same as that of an implementation process in which flattening processing is performed on the three first tiny metal blocks 102' on the upper bonding surface of the electronic element 103. Therefore, this step is not illustrated in FIG. 5.

Therefore, the three first support parts 102a are disposed on the upper bonding surface of the electronic element 103, the three second support parts 104a are disposed on the lower bonding surface of the electronic element 103, and the first support parts 102a and the second support parts 104a are symmetrically disposed. Therefore, bonding the upper bonding surface of the electronic element 103 to the first bonding surface of the first substrate 101 can control the thickness and warpage of the first bonding layer 102, so that the first bonding layer 102 has a flat surface and a uniform thickness, and bonding the lower bonding surface of the electronic element 103 to the first bonding surface of the second substrate 105 can control the thickness and warpage of the second bonding layer 104, so that the second bonding layer 104 has a flat surface and a uniform thickness.

As shown in FIG. 6, first, three first tiny metal blocks 102' (only two first tiny metal blocks 102' are illustrated in FIG. 6) are separately implanted into an upper bonding surface of the electronic element 103 by using an ultrasonic wave bonding head and cutter 400, so that the three first tiny metal blocks 102' are fastening on the upper bonding surface of the electronic element 103. A side that is of each first tiny metal block 102' and that is close to the upper bonding surface of the electronic element 103 is silkworm-shaped, and a height of each first tiny metal block 102' is greater than the thickness of the first bonding layer 102. For example, the height of the first tiny metal block 102' falls between 0.02 mm and 10 mm, and the thickness of the first bonding layer 102 falls between 0.01 mm and 10 mm.

In addition, after the three first tiny metal blocks 102' are implanted into the upper bonding surface of the electronic element 103, the electronic element 103 is turned over, and the three first tiny metal blocks 102' (only two second tiny metal blocks 104' are illustrated in FIG. 6) are separately placed in three holes of a positioning plate 500, to prevent the three second tiny metal blocks 104' from hindering a subsequent ultrasonic wave operation. Then, three second tiny metal blocks 104' are separately implanted into a lower bonding surface of the electronic element 103 by using the ultrasonic wave bonding head and cutter 400, so that the three second tiny metal blocks 104' are fastening on the lower bonding surface of the electronic element 103. A side that is of each second tiny metal block 104' and that is close to the lower bonding surface of the electronic element 103 is silkworm-shaped, and a height of each second tiny metal block 104' is greater than the thickness of the second bonding layer 104.

Therefore, three tiny metal blocks are fastening on each of the upper bonding surface and the lower bonding surface of the electronic element 103.

Next, the electronic element 103 with the lower bonding surface facing downwards is placed in a fixture 601, so that the three second tiny metal blocks 104' are separately placed in three holes of the fixture 601. Then, pressure is applied to the fixture 601 in a direction of an arrow shown in FIG. 6. Two thickness control rings 602 are used to perform flattening processing on the three first tiny metal blocks 102', and the other two thickness control rings 602 have a height maintaining auxiliary function to adjust heights of the three second tiny metal blocks 104', so that the heights of the three second tiny metal blocks 104' are the same as the thickness of the first bonding layer 102. In this way, three first support parts 102a are fastening on the upper bonding surface of the electronic element 103.

Then, after flattening processing on the three first tiny metal blocks 102' on the upper bonding surface of the electronic element 103 is completed, the electronic element 103 with the upper bonding surface facing downwards is placed in the fixture 601, so that the three first support parts 102a are separately placed in the three holes of the fixture 601. Then, pressure is applied to the fixture 601 in a direction of an arrow shown in FIG. 6. Two thickness control rings 602 are used to perform flattening processing on the three second tiny metal blocks 104', and the other two control rings 602 have a height maintaining auxiliary function to adjust heights of the three second tiny metal blocks 104', so that the heights of the three second tiny metal blocks 104' are the same as the thickness of the second bonding layer 104. In this way, three second support parts 104a are fastening on the lower bonding surface of the electronic element 103. It should be noted that a principle of an implementation process of this step is the same as that of an implementation process in which flattening processing is performed on the three first tiny metal blocks 102' on the upper bonding surface of the electronic element 103. Therefore, this step is not illustrated in FIG. 6.

Therefore, the three first support parts 102a are disposed on the upper bonding surface of the electronic element 103, the three second support parts 104a are disposed on the lower bonding surface of the electronic element 103, and the first support parts 102a and the second support parts 104a are symmetrically disposed. Therefore, bonding the upper bonding surface of the electronic element 103 to the first bonding surface of the first substrate 101 can control the thickness and warpage of the first bonding layer 102, so that the first bonding layer 102 has a flat surface and a uniform thickness, and bonding the lower bonding surface of the electronic element 103 to the first bonding surface of the second substrate 105 can control the thickness and warpage of the second bonding layer 104, so that the second bonding layer 104 has a flat surface and a uniform thickness.

In addition, because a support part is disposed on each of the upper bonding surface and the lower bonding surface of the electronic element 103, the upper bonding surface or the lower bonding surface of the electronic element 103 may be randomly grasped, so that grasping efficiency is improved.

It should be noted that in addition to the foregoing manners, three second support parts 104a may be disposed on the upper bonding surface of the electronic element 103, and three first support parts 102a may be disposed on the lower bonding surface of the electronic element 103. Similarly, the first substrate 101 and the second substrate 105 may be provided with support parts on both sides. For a specific implementation process, refer to the foregoing process. Details are not described herein again. In addition, a support part may be fastening on only one bonding surface of the electronic element 103. Similarly, the first substrate 101 and the second substrate 105 may also be provided with support parts on one side.

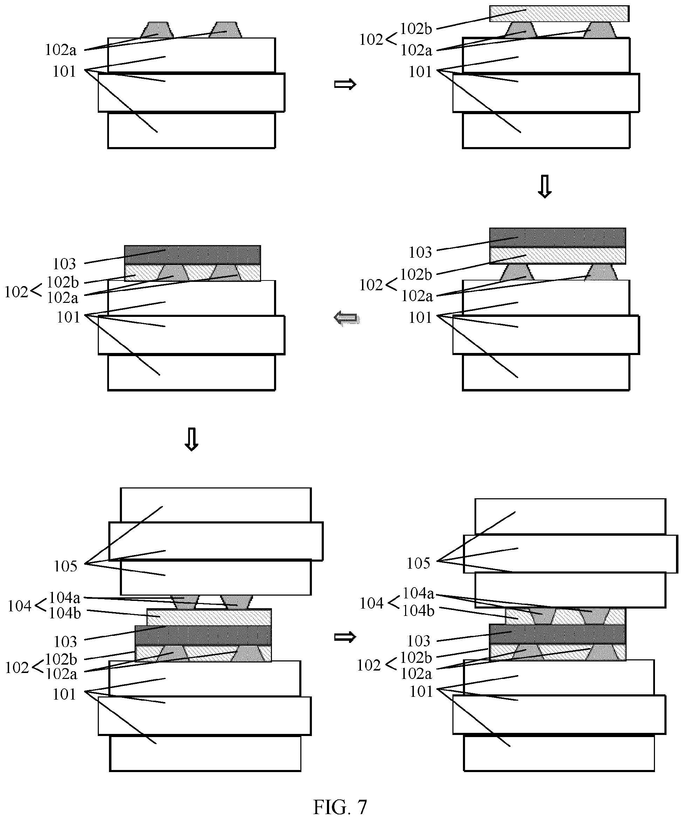

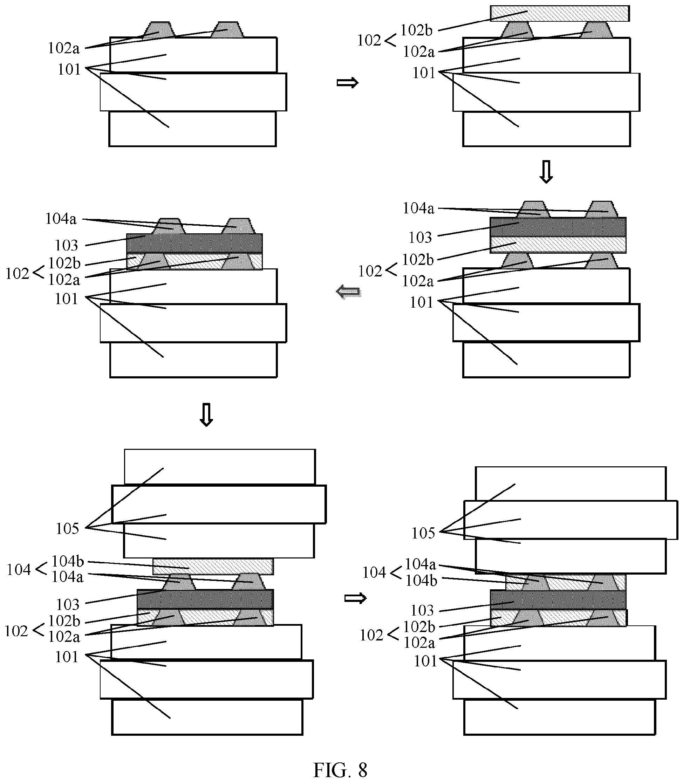

Based on the foregoing description, there are a plurality of manners of fastening the support part. Therefore, there are also a plurality of implementations for manufacturing the packaging structure 100. With reference to FIG. 7 and FIG. 8, the following uses examples to describe a specific implementation process of manufacturing the packaging structure 100. For ease of description, in FIG. 7 and FIG. 8, the first support part 102a and the second support part 104a are silkworm-shaped, and quantities of first support parts 102a and second support parts 104a are set to three. In addition, because FIG. 7 and FIG. 8 are cross-sectional diagrams, only two first support parts 102a and two second support parts 104a are illustrated in FIG. 7 and FIG. 8.

As shown in FIG. 7, first, three first support parts 102a are implanted into the first bonding surface of the first substrate 101, a height of each first support part 102a is the same as the thickness of the first bonding layer 102, and a melting point of each first support part 102a is higher than the maximum temperature at which the first bonding layer 102 is formed. In addition, the first bonding material 102b (a soldering lug shown in FIG. 7) is mounted on the three first support parts 102a, and then the electronic element 103 is mounted on the first bonding material 102b. After the first reflow, the electronic element 103 is soldered to the first bonding surface of the first substrate 101 by using the first bonding layer 102. Then, the second bonding material 104b is mounted on an upper surface of the electronic element 103, and three second support parts 104a are mounted on the first bonding surface of the second substrate 105. The three second support parts 104a face and is attached to an upper surface of the second bonding material 104b, a height of each second support part 104a is the same as the thickness of the second bonding layer 104, and a melting point of each second support part 104a is higher than the maximum temperature at which the second bonding layer 104 is formed. After the second reflow, the second substrate 105 is soldered to the electronic element 103 by using the second bonding layer 104. Therefore, the first substrate 101, the electronic element 103, and the second substrate 105 may be bonded together to form the packaging structure 100.

In addition, because the first support part 102a is disposed in the first bonding layer 102, in a process of the second reflow, the height of the first support part 102a can be maintained, the first bonding material 102b does not overflow even if the first support part 102a is melted, and a melting point of the first bonding material 102b does not need to be higher than a melting point of the second bonding material 104b, so that types of the first bonding material 102b and the second bonding material 104b are not limited.

As shown in FIG. 8, first, three first support parts 102a are implanted into the first bonding surface of the first substrate 101, a height of each first support part 102a is the same as the thickness of the first bonding layer 102, and a melting point of each first support part 102a is higher than a maximum temperature at which the first bonding layer 102 is formed. In addition, the first bonding material 102b (a soldering lug shown in FIG. 8) is mounted on the three first support parts 102a, and then the electronic element 103 is mounted on the first bonding material 102b. The three second support parts 104a are implanted into an upper surface of the electronic element 103, a height of each second support part 104a remains the same as the thickness of the second bonding layer 104, and a melting point of each second support part 104a is higher than the maximum temperature at which the second bonding layer 104 is formed. After the first reflow, the electronic element 103 is soldered to the first substrate 101 by using the first bonding layer 102. Then, the second bonding material 104b is mounted on the upper surface of the electronic element 103, and the second substrate 105 is mounted on an upper surface of the second bonding material 104b. After the second reflow, the second substrate 105 is soldered to the electronic element 103 by using the second bonding layer 104. Therefore, the first substrate 101, the electronic element 103, and the second substrate 105 may be bonded together to form the packaging structure 100.

In addition, because the first support part 102a is disposed in the first bonding layer 102, in a process of the second reflow, the height of the first support part 102a can be maintained, the first bonding material 102b does not overflow even if the first support part 102a is melted, and a melting point of the first bonding material 102b does not need to be higher than a melting point of the second bonding material 104b, so that types of the first bonding material 102b and the second bonding material 104b are not limited.

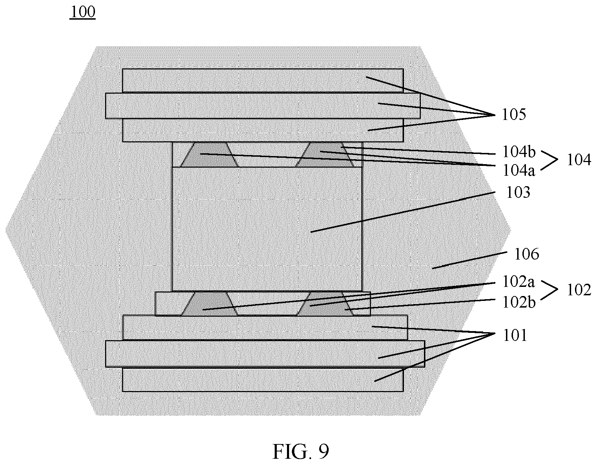

FIG. 9 is a schematic diagram of a structure of a packaging structure according to an embodiment of this application. As shown in FIG. 9, different from the packaging structure 100 shown in FIG. 2, the packaging structure 100 provided in this application may further include a plastic packaging material 106. The first substrate 101, the first bonding layer 102, a part of the electronic element 103, the second bonding layer 104, and the second substrate 105 are all disposed in the plastic sealing material 106, to protect each component and an electrical connection between the components in the packaging structure 100 by using the plastic packaging material 106, thereby facilitating use of the packaging structure 100.

A specific type of the plastic packaging material 106 is not limited in this application. In addition, to implement input and/or output of a signal, one end of a terminal in the electronic element 103 is located inside the plastic packaging material 106, and the other end of the terminal is located outside the plastic packaging material 106, to implement an electrical connection between the electronic element 103 and another component. In addition, to accelerate heat dissipation of the packaging structure 100, the second conductive layer in the first substrate 101 is exposed to the outside of the plastic packaging material 106, and the fourth conductive layer in the second substrate 105 is also exposed to the outside of the plastic packaging material 106.

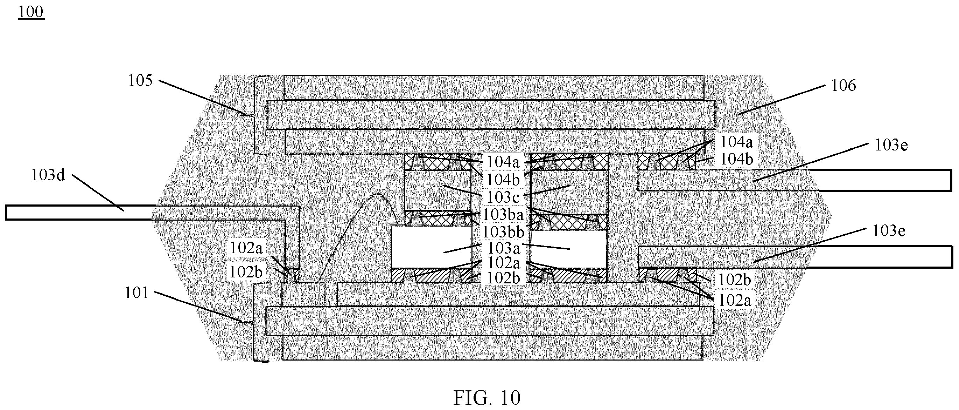

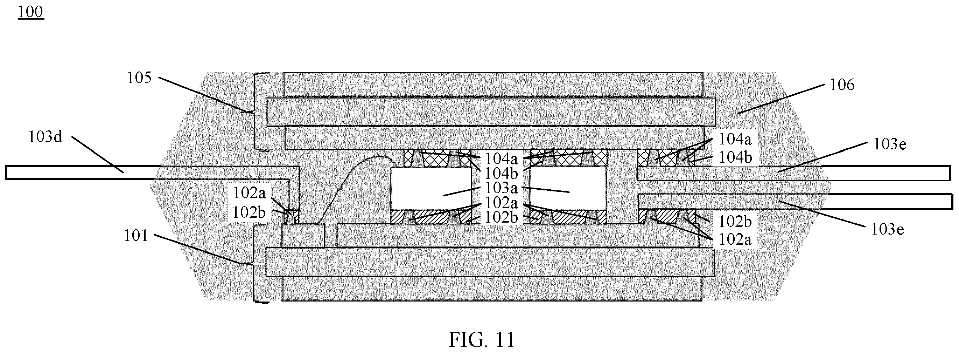

In this application, the electronic element 103 may include a plurality of implementations. With reference to FIG. 10 and FIG. 11, the following uses two feasible implementations as examples to describe a specific implementation of the electronic element 103.

In one feasible implementation, to implement a connection between the packaging structure 100 and another component, as shown in FIG. 10, if the packaging structure 100 includes a plurality of unconnected first bonding layers 102 and a plurality of unconnected second bonding layers 104, the electronic element 103 may include a chip 103a, a third bonding layer 103b, an interconnection column 103c, a signal terminal 103d, and a power terminal 103e. For ease of description, in FIG. 10, two chips 103a are used as an example for illustration, two interconnection columns 103c are used as an example for illustration, two power terminals 103e are used as an example for illustration, and one signal terminal 103d is used as an example for illustration.

In this application, the chip 103a is located between a first bonding layer 102 other than a first bonding layer 102 corresponding to the signal terminal 103d and a first bonding layer 102 corresponding to the power terminal 103e and the third bonding layer 103b, and the interconnection column 103c is located between a third bonding layer 103b corresponding to the chip 103a and a corresponding second bonding layer 104.

There may be one or more chips 103a, and there may be one or more interconnection columns 103c. Generally, when there is one chip 103a, the chip 103a is bonded to the first conductive surface of the first substrate 101 by using one first bonding layer 102, the chip 103a is bonded to one interconnection column 103c by using one third bonding layer 103b, and the interconnection column 103c is bonded to the first conductive surface of the second substrate 105 by using one second bonding layer 104. When there are a plurality of chips 103a, each chip 103a is bonded to the first conductive surface of the first substrate 101 by using one first bonding layer 102, each chip 103a is bonded to one interconnection column 103c by using one third bonding layer 103b, and each interconnection column 103c is bonded to the first conductive surface of the second substrate 105 by using one second bonding layer 104.

In this way, when thicknesses of a plurality of chips 103a are the same, the thicknesses of the chips 103a may be adjusted by using thicknesses of all interconnection columns 103c, so that an overall thickness of the packaging structure 100 meets an actual thickness requirement. The thicknesses of all the interconnection columns 103c are usually the same. When thicknesses of a plurality of chips 103a are different, the thicknesses of the chips 103a may be adjusted by using all interconnection columns 103c, so that the packaging structure 100 keeps a flat surface, and reliability of the packaging structure 100 is improved.

In addition, when there is a connection relationship between a plurality of chips 103a, first bonding layers 102 corresponding to all the chips 103a are bonded to a same conductive area in the first conductive surface of the first substrate 101, and/or interconnection columns 103c corresponding to all the chips 103a are bonded to a same conductive area in the first conductive surface of the second substrate 105.

For example, as shown in FIG. 10, if chips 103a include an IGBT and an FRD that are connected, a conductive area that is in the first conductive surface of the first substrate 101 and that is bonded to a first bonding layer 102 corresponding to the IGBT is the same as a conductive area that is in the first conductive surface of the first substrate 101 and that is bonded to a first bonding layer 102 corresponding to the FRD, and a conductive area that is in the first conductive surface of the second substrate 105 and that is bonded to an interconnection column 103c corresponding to the IGBT is the same as a conductive area that is in the first conductive surface of the second substrate 105 and that is bonded to an interconnection column 103c corresponding to the FRD.

In this application, the signal terminal 103d may transmit, to the chip 103a, a signal output by another component, or may transmit, to another component, a signal output by the chip 103a, or may implement the foregoing two processes. This is not limited in this application. A specific quantity of signal terminals 103d is not limited in this application.

Based on this, to implement output and/or input of a signal, the signal terminal 103d is disposed extending from the inside of the packaging structure 100 to the outside of the packaging structure 100, an end of the signal terminal 103d that is located inside the packaging structure 100 is located on a first bonding layer 102 other than the first bonding layer 102 corresponding to the chip 103a and the first bonding layer 102 corresponding to the power terminal 103e, the signal terminal 103d is electrically connected to the chip 103a, and the first bonding layer 102 corresponding to the chip 103a and the first bonding layer 102 corresponding to the signal terminal 103d correspond to different conductive areas in the first conductive surface of the first substrate 101.

The signal terminal 103d may be electrically connected to the chip 103a in a plurality of manners. As shown in FIG. 10, an electrical connection between the two is implemented in an aluminum Al wire bonding manner. A wire needs to be led out from the chip 103a to a conductive area that is in the first conductive surface of the first substrate 101 and that is bonded to the signal terminal 103d. Therefore, placement space of the wire needs to be reserved above the chip 103a by using the interconnection column 103c, so that a reliable connection between the signal terminal 103d and the chip 103a is ensured, thereby avoiding interference of another factor.

In this application, the power terminal 103e may transmit a voltage or a current obtained after power conversion of the chip 103a to another component, for example, transmit an alternating current to another component. A specific quantity of power terminals 103e is not limited in this application.

Based on this, to implement power transmission of the power terminal 103e, the power terminal 103e may be directly connected to the chip 103a, or may be indirectly connected to the chip 103a by using the interconnection column 103c.

When the power terminal 103e is directly connected to the chip 103a, the power terminal 103e may be disposed extending from the inside of the packaging structure 100 to the outside of the packaging structure 100, an end of the power terminal 103e that is located inside the packaging structure 100 is located on a first bonding layer 102 other than the first bonding layer 102 corresponding to the chip 103a and the first bonding layer 102 corresponding to the signal terminal 103d, and the first bonding layer 102 corresponding to the chip 103a and the first bonding layer 102 corresponding to the power terminal 103e correspond to different conductive areas in the first conductive surface of the first substrate 101.

Therefore, a conductive area that is in the first conductive surface of the first substrate 101 and to which the power terminal 103e is connected by using one first bonding layer 102 is the same as a conductive area that is in the first conductive surface of the first substrate 101 and to which the chip 103a is connected by using another first bonding layer 102, so that the power terminal 103e and the chip 103a can be electrically interconnected.

When the power terminal 103e is indirectly connected to the chip 103a by using the interconnection column 103c, the power terminal 103e may be located on a second bonding layer 104 other than a second bonding layer 104 corresponding to the interconnection column 103c. The second bonding layer 104 corresponding to the interconnection column 103c and a second bonding layer 104 corresponding to the power terminal 103e correspond to a same conductive area in the first conductive surface of the second substrate 105.

Therefore, a conductive area that is in the first conductive surface of the second substrate 105 and to which the power terminal 103e is connected by using one second bonding layer 104 is the same as a conductive area that is in the first conductive surface of the second substrate 105 and to which the interconnection column 103c is connected by using another second bonding layer 104, so that the power terminal 103e and the chip 103a can be electrically interconnected.

It should be noted that when there is one power terminal 103e, the power terminal 103e may use either of the foregoing position relationships. When there are a plurality of power terminals 103e, the plurality of power terminals 103e may use either of the foregoing position relationships, or may use the foregoing two position relationships (this manner is used for illustration in FIG. 10). This is not limited in this application.

In this application, the third bonding layer 103b may include a third bonding material 103bb and at least one third support part 103ba. For ease of description, an example in which one third bonding layer 103b uses two third support parts 103ba is illustrated in FIG. 10.

A specific type of the third bonding material 103bb may be set based on a bonding manner, and is not limited in this application. Optionally, when a type of the third bonding layer 103b includes a solder layer, the third bonding material 103bb may include a soldering lug or solder paste. When the type of the third bonding layer 103b includes a sintering layer, the third bonding material 103bb may include a powdered material or a paste material. When the type of the third bonding layer 103b includes a solder layer and a sintering layer, the third bonding material 103bb in the solder layer may include a soldering lug or solder paste, and the third bonding material 103bb in the sintering layer may include a powdered material or a paste material.

The third support part 103ba may be set to a micrometer-scale size, that is, a size of the third support part 103ba in each dimension is at a micrometer scale. Because the size of the third support part 103ba in each dimension is at a micrometer scale, compared with a volume of the third bonding layer 103b with a size of several millimeters, the size of the third support part 103ba is quite small, so that the third support part 103ba has quite small impact on a process of the third bonding layer 103b during bonding, and does not prevent a bubble formed on the third bonding layer 103b from escaping from the third bonding material 103bb. This avoids an excessively high void ratio of the third bonding layer 103b, and therefore has small impact on bonding of the third bonding layer 103b, to avoid a reduction of a bonding effect between the chip 103a and the interconnection column 103c that is caused by an excessively large size of the at least one third support part 103ba, so that the chip 103a and the interconnection column 103c can be reliably bonded.

Optionally, third support parts 103ba in different third bonding layers 103b may have a same shape or different shapes. A plurality of third support parts 103ba in a same third bonding layer 103b may have a same shape or different shapes. A shape of the third support part 103ba is not limited in this application. Optionally, the shape of the third support part 103ba includes at least one of a spherical shape, a rectangular shape, an ellipsoid shape, a wedge shape, or a silkworm shape.

Optionally, third support parts 103ba in different third bonding layers 103b may have a same material or different materials. A plurality of third support parts 103ba in a same third bonding layer 103b may have a same material or different materials. A material of the third support part 103ba is not limited in this application. Optionally, the third support part 103ba is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the third support part 103ba is any one of a covering material, a coating material, a strip material, and a wire material, for example, a metal coating or a heterogeneous metal covering. Therefore, manufacturing costs of the packaging structure 100 are reduced.

Optionally, there may be a same quantity or different quantities of third support parts 103ba in different third bonding layers 103b. A quantity of third support parts 103ba in any third bonding layer 103b is not limited in this application. Therefore, the quantity of third support parts 103ba in the third bonding layer 103b is adjustable. Generally, the quantity of third support parts 103ba may be greater than or equal to 3, to further improve a bonding effect of the third bonding layer 103b and ensure a support balance between the chip 103a and the interconnection column 103c.

Optionally, third support parts 103ba in different third bonding layers 103b may have a same position or different positions. A position of a third support part 103ba in any third bonding layer 103b is not limited in this application. Therefore, the position of the third support part 103ba in the third bonding layer 103b is flexible, so that a third support part 103ba of a required size is implanted at a required position.

In this application, to prevent the third support part 103ba from being melted by the third bonding material 103bb and prevent a solder from moving to the outside of the third bonding layer 103b during bonding, the third support part 103ba may be fastening. Further, because the third support part 103ba has small impact on bonding of the third bonding layer 103b, the third support part 103ba may have a plurality of disposing positions, the operation is convenient and quick, and generation efficiency is high.

Optionally, the at least one third support part 103ba may be fastening on a side that is of the chip 103a and that is close to the interconnection column 103c.

Optionally, the at least one third support part 103ba may be fastening on a side that is of the interconnection column 103c and that is close to the chip 103a.

Optionally, the at least one third support part 103ba may be fastening on a side that is of the chip 103a and that is close to the interconnection column 103c and a side that is of the interconnection column 103c and that is close to the chip 103a, and third support parts 103ba on the side that is of the chip 103a and that is close to the interconnection column 103c and third support parts 103ba on the side that is of the interconnection column 103c and that is close to the chip 103a are alternately disposed.

A manner of fastening the third support part 103ba is not limited in this application. Optionally, the third support part 103ba is fastening in any one of the following manners: an ultrasonic wave, sintering, electroplating, or brazing.

In this application, a height of the at least one third support part 103ba is the same as a thickness of the third bonding layer 103b, and a melting point of the at least one third support part 103ba is higher than a maximum temperature at which the third bonding layer 103b is formed. The thickness of the third bonding layer 103b may be set based on an actual case, and is not limited in this application. The height of the third support part 103ba may be set based on a thickness of a corresponding third bonding layer 103b, and a specific value of the height of the third support part 103ba is not limited. Optionally, third support parts 103ba in different third bonding layers 103b may have a same height or different heights.

Based on the foregoing setting, in a process of forming the third bonding layer 103b, the at least one third support part 103ba does not completely dissolve in the third bonding material 103bb in the third bonding layer 103b, so that the thickness of the at least one third support part 103ba remains the same as the thickness of the third bonding layer 103b, and the third bonding layer 103b with the height of the at least one third support part 103ba is formed by using the at least one third support part 103ba. In addition, when a plurality of times of reflow are required for the packaging structure 100, the at least one third support part 103ba does not move with movement of the third bonding material 103bb, so that the at least one third support part 103ba is evenly distributed in the third bonding layer 103b, and based on a support function of the at least one third support part 103ba, the third bonding layer 103b can withstand extrusion without deformation, and the third bonding material 103bb in the third bonding layer 103b does not overflow even if the at least one third support part 103ba is remelted, thereby ensuring good quality and bonding strength of the third bonding layer 103b, and avoiding a phenomenon such as electrical short-circuiting or a failure of the chip 103a that is caused by insufficiency of the third bonding material 103bb below the interconnection column 103c. In this way, it is ensured that the third bonding layer 103b has a flat surface and a uniform thickness, and process requirements for the thickness and warpage of the third bonding layer 103b are met. In addition, unlimited types of the third bonding material 103bb in the third bonding layer 103b facilitate manufacturing of the third bonding layer 103b, and reduce costs of the third bonding layer 103b.

Therefore, based on the flat surface and the uniform thickness of the third bonding layer 103b, a good bonding effect and an electrical connection are implemented between the chip 103a and the interconnection column 103c by using the third bonding layer 103b, and bonding costs are further reduced.

In conclusion, the first bonding layer 102, the second bonding layer 104, and the third bonding layer 103b are disposed, so that the first conductive surface of the first substrate 101, the first bonding layer 102, the chip 103a, the third bonding layer 103b, the interconnection column 103c, the second bonding layer 104, and the first conductive surface of the second substrate 105 are securely bonded and reliably connected, the signal terminal 103d and the first conductive surface of the first substrate 101 are securely bonded and reliably connected, and the power terminal 103e and the first conductive surface of the first substrate 101 and/or the first conductive surface of the second substrate 105 are securely bonded and reliably connected. This improves reliability of the packaging structure 100, and reduces bonding costs of the packaging structure 100. The packaging structure 100 can further implement a complete power conversion process.

In the implementation shown in FIG. 11, if the packaging structure 100 includes a plurality of unconnected first bonding layers 102 and a plurality of unconnected second bonding layers 104, the electronic element 103 includes a chip 103a, a signal terminal 103d, and a power terminal 103e. For ease of description, in FIG. 11, two chips 103a are used as an example for illustration, two power terminals 103e are used as an example for illustration, and one signal terminal 103d is used as an example for illustration.

In this application, the chip 103a is located between a first bonding layer 102 other than a first bonding layer 102 corresponding to the signal terminal 103d and a first bonding layer 102 corresponding to the power terminal 103e and a corresponding second bonding layer 104.

There may be one or more chips 103a. Generally, when there is one chip 103a, the chip 103a is bonded to the first conductive surface of the first substrate 101 by using one first bonding layer 102, and the chip 103a is bonded to the first conductive surface of the second substrate 105 by using one second bonding layer 104. When there are a plurality of chips 103a, each chip 103a is bonded to the first conductive surface of the first substrate 101 by using one first bonding layer 102, and each chip 103a is bonded to the first conductive surface of the second substrate 105 by using one second bonding layer 104.

In this way, the foregoing connection manner is usually applicable to a scenario in which thicknesses of a plurality of chips 103a are the same, so that an overall thickness of the packaging structure 100 can meet an actual thickness requirement, the packaging structure 100 keeps a flat surface, and reliability of the packaging structure 100 is improved.

In addition, when there is a connection relationship between a plurality of chips 103a, first bonding layers 102 corresponding to all the chips 103a are bonded to a same conductive area in the first conductive surface of the first substrate 101, and/or second bonding layers 104 corresponding to all the chips 103a are bonded to a same conductive area in the first conductive surface of the second substrate 105.

For example, as shown in FIG. 11, if chips 103a include an IGBT and an FRD that are connected, a conductive area that is in the first conductive surface of the first substrate 101 and that is bonded to a first bonding layer 102 corresponding to the IGBT is the same as a conductive area that is in the first conductive surface of the first substrate 101 and that is bonded to a first bonding layer 102 corresponding to the FRD, and a conductive area that is in the first conductive surface of the second substrate 105 and that is bonded to a second bonding layer 104 corresponding to the IGBT is the same as a conductive area that is in the first conductive surface of the second substrate 105 and that is bonded to a second bonding layer 104 corresponding to the FRD.

In this application, the signal terminal 103d may transmit, to the chip 103a, a signal output by another component, or may transmit, to another component, a signal output by the chip 103a, or may implement the foregoing two processes. This is not limited in this application. A specific quantity of signal terminals 103d is not limited in this application.

Based on this, the signal terminal 103d is bonded to a signal terminal of the first substrate 101 through a soldering or sintering process. A metal terminal has a specific weight, and pressure is often applied to the terminal to prevent terminal deformation during manufacturing of the packaging structure 100. Therefore, to implement output and/or input of a signal, the signal terminal 103d is disposed extending from the inside of the packaging structure 100 to the outside of the packaging structure 100, and to avoid overflow of the first bonding material 101b, an end of the signal terminal 103d that is located inside the packaging structure 100 is located on a first bonding layer 102 other than a first bonding layer 102 corresponding to the chip 103a and the first bonding layer 102 corresponding to the power terminal 103e. The first bonding layer 102 includes a first bonding material 102b and a first support part 102a that is fastening on the first conductive surface of the first substrate 101, the signal terminal 103d is electrically connected to the chip 103a, and the first bonding layer 102 corresponding to the chip 103a and the first bonding layer 102 corresponding to the signal terminal 103d correspond to different conductive areas in the first conductive surface of the first substrate 101, to implement an interconnection between a signal electrode of the chip 103a and the signal terminal 103d above the first substrate 101.

The signal terminal 103d and the chip 103a may be electrically connected in a plurality of manners. For example, in FIG. 11, the signal electrode of the chip 103a is interconnected to the signal terminal above the first substrate 101 in an aluminum Al wire bonding manner, a bonding manner of an aluminum Al-covered copper Cu wire, or the like, to implement an electrical connection between the signal terminal 103d and the chip 103a. In this application, the power terminal 103e may transmit a voltage or a current obtained after power conversion of the chip 103a to another component, for example, transmit an alternating current to another component. A specific quantity of power terminals 103e is not limited in this application.

Based on this, to implement power transmission of the power terminal 103e, the power terminal 103e may be connected to the chip 103a by using the first bonding layer 102, or may be connected to the chip 103a by using the second bonding layer 104.

When the power terminal 103e is connected to the chip 103a by using the first bonding layer 102, the power terminal 103e is disposed extending from the inside of the packaging structure 100 to the outside of the packaging structure 100, an end of the power terminal 103e that is located inside the packaging structure 100 is located on a first bonding layer 102 other than a first bonding layer 102 corresponding to the chip 103a and the first bonding layer 102 corresponding to the signal terminal 103d, the first bonding layer 102 includes a first bonding material 102b and a first support part 102a that is fastening on the first conductive surface of the first substrate 101, and the first bonding layer 102 corresponding to the chip 103a and the first bonding layer 102 corresponding to the power terminal 103e correspond to a same conductive area in the first conductive surface of the first substrate 101.

Therefore, a conductive area that is in the first conductive surface of the first substrate 101 and to which the power terminal 103e is connected by using one first bonding layer 102 is the same as a conductive area that is in the first conductive surface of the first substrate 101 and to which the chip 103a is connected by using another first bonding layer 102, so that the power terminal 103e and the chip 103a can be electrically interconnected.

When the power terminal 103e is connected to the chip 103a by using the second bonding layer 104, the power terminal 103e is located on a second bonding layer 104 other than a second bonding layer 104 corresponding to the chip 103a, the second bonding layer 104 includes a second bonding material 104b and a second support part 104a that is fastening on the first conductive surface of the second substrate 105, and the second bonding layer 104 corresponding to the chip 103a and a second bonding layer 104 corresponding to the power terminal 103e correspond to a same conductive area in the first conductive surface of the second substrate 105.

Therefore, a conductive area that is in the first conductive surface of the second substrate 105 and to which the power terminal 103e is connected by using one second bonding layer 104 is the same as a conductive area that is in the first conductive surface of the second substrate 105 and to which the chip 103a is connected by using another second bonding layer 104, so that the power terminal 103e and the chip 103a can be electrically interconnected.

It should be noted that when there is one power terminal 103e, the power terminal 103e may use either of the foregoing position relationships. When there are a plurality of power terminals 103e, the plurality of power terminals 103e may use either of the foregoing position relationships, or may use the foregoing two position relationships (this manner is used for illustration in FIG. 11). This is not limited in this application.

In conclusion, the first bonding layer 102, the second bonding layer 104, and the third bonding layer 103b are disposed, so that the first conductive surface of the first substrate 101, the first bonding layer 102, the chip 103a, the second bonding layer 104, and the first conductive surface of the second substrate 105 are securely bonded and reliably connected, the signal terminal 103d and the first conductive surface of the first substrate 101 are securely bonded and reliably connected, and the power terminal 103e and the first conductive surface of the first substrate 101 and/or the first conductive surface of the second substrate 105 are securely bonded and reliably connected. This improves reliability of the packaging structure 100, and reduces bonding costs of the packaging structure 100. The packaging structure 100 can further implement a complete power conversion process.

It should be noted that in addition to the foregoing two manners, when there are a plurality of chips 103a, each of some of the chips 103a is bonded to the first conductive surface of the first substrate 101 by using one first bonding layer 102, each chip 103a is bonded to one interconnection column 103c by using one third bonding layer 103b, and each interconnection column 103c is bonded to the first conductive surface of the second substrate 105 by using one second bonding layer 104. Each of the other chips 103a is bonded to the first conductive surface of the first substrate 101 by using one first bonding layer 102, and each chip 103a is bonded to the first conductive surface of the second substrate 105 by using one second bonding layer 104.

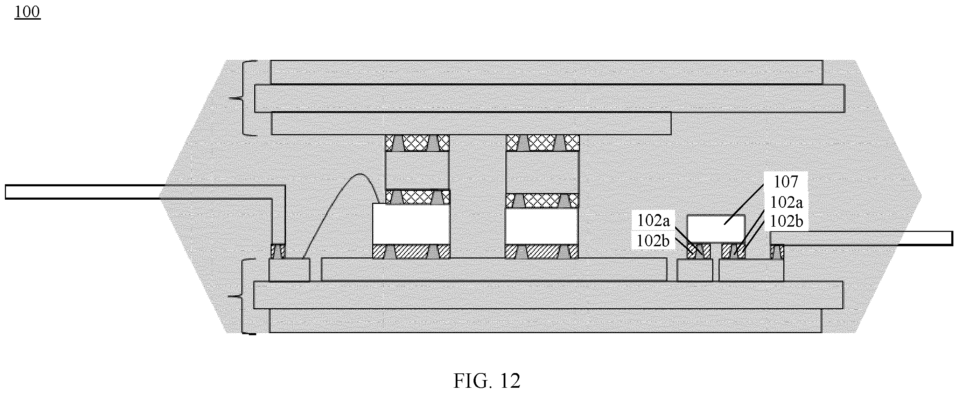

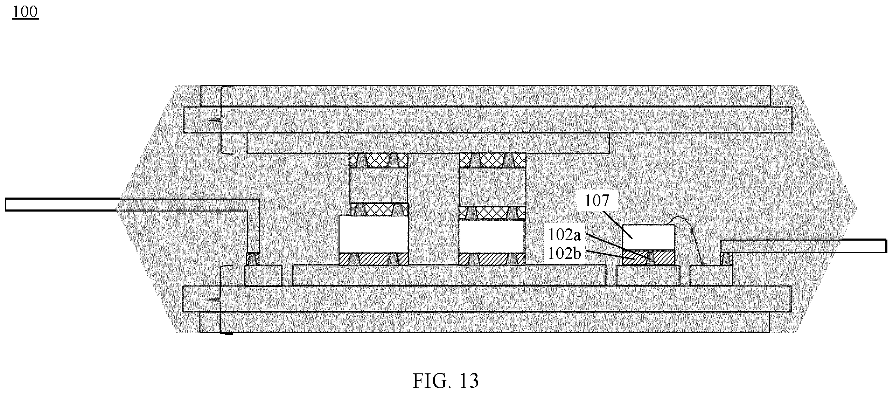

In this way, when thicknesses of a plurality of chips 103a are different, and a thickness of a corresponding chip 103a may be adjusted by using a thickness of the interconnection column 103c, so that an overall thickness of the packaging structure 100 meets an actual thickness requirement, the packaging structure 100 keeps a flat surface, and reliability of the packaging structure 100 is improved. Based on the foregoing description and the embodiment shown in FIG. 10, as shown in FIG. 12 and FIG. 13, the electronic element 103 may further include a sensor 107. A type of the sensor 107 is not limited in this application. For example, the sensor 107 may be an NTC temperature sensor 107. In addition, a bonding manner of the sensor 107 is not limited in this application.

In a feasible implementation, optionally, as shown in FIG. 12, both ends of the sensor 107 and a sensor terminal may be separately located on first bonding layers 102 other than the first bonding layer 102 corresponding to the chip 103a, the first bonding layer 102 corresponding to the signal terminal 103d, and the first bonding layer 102 corresponding to the power terminal 103e, the first bonding layer 102 includes a first bonding material 102b and a first support part 102a that is fastening on the first conductive surface of the first substrate 101, and the first bonding layer 102 corresponding to the chip 103a and the two first bonding layers 102 corresponding to the sensor 107 correspond to different conductive areas in the first conductive surface of the first substrate 101, so that the sensor 107 is bonded to the first substrate 101, and a signal of the sensor 107 is led out to the outside of the packaging structure 100 by using the sensor terminal. In another feasible implementation, optionally, as shown in FIG. 13, one end of the sensor 107 is located on a first bonding layer 102 other than the first bonding layer 102 corresponding to the chip 103a, the first bonding layer 102 corresponding to the signal terminal 103d, and the first bonding layer 102 corresponding to the power terminal 103e, the first bonding layer 102 includes a first bonding material 102b and a first support part 102a that is fastening on the first conductive surface of the first substrate 101, and the other end of the sensor 107 is disposed extending from the inside of the packaging structure 100 to the outside of the packaging structure 100 by using a transmission wire, the first bonding layer 102 corresponding to the chip 103a and the first bonding layer 102 corresponding to the sensor 107 correspond to different conductive areas in the first conductive surface of the first substrate 101, and the other end of the sensor 107 is electrically connected to a sensor terminal (in FIG. 13, an upper part of the sensor 107 is electrically connected, through a wire, to a bonding layer that is of the first substrate 101 and that is bonded to the sensor terminal), so that the sensor 107 is bonded to the first substrate 101, and a signal of the sensor 107 is led out to the outside of the packaging structure 100 by using the sensor terminal.

Different from the setting manner of the signal terminal 103d, the sensor terminal is electrically connected to the sensor 107 by using an aluminum Al wire. Another setting manner of the sensor terminal is the same as the setting manner of the signal terminal 103d. For a specific implementation, refer to the foregoing description content. Details are not described herein again. It should be noted that the sensor 107 may be further disposed with reference to the packaging structure 100 shown in FIG. 11. FIG. 12 and FIG. 13 are only feasible examples. In addition to the foregoing components, the electronic element 103 may further include but is not limited to a resistor, a capacitor, or an inductor. The first bonding manner of the sensor 107 may be used as manners of bonding the resistor, the capacitor, and the inductor to the sensor 107. Details are not described herein again.

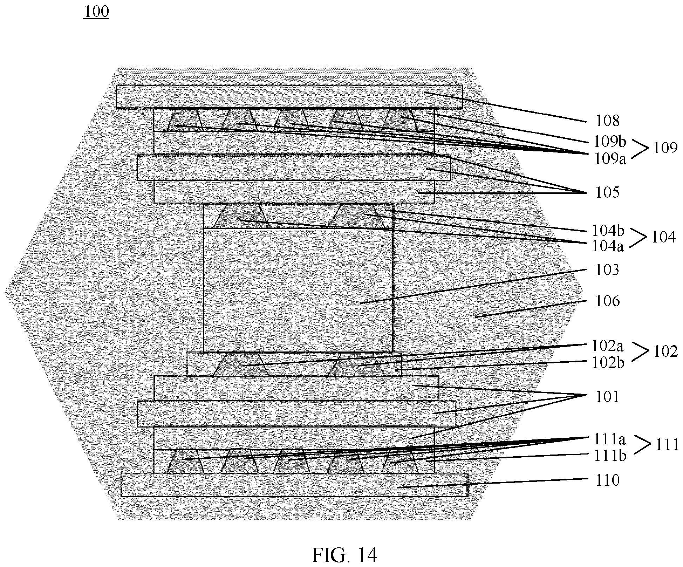

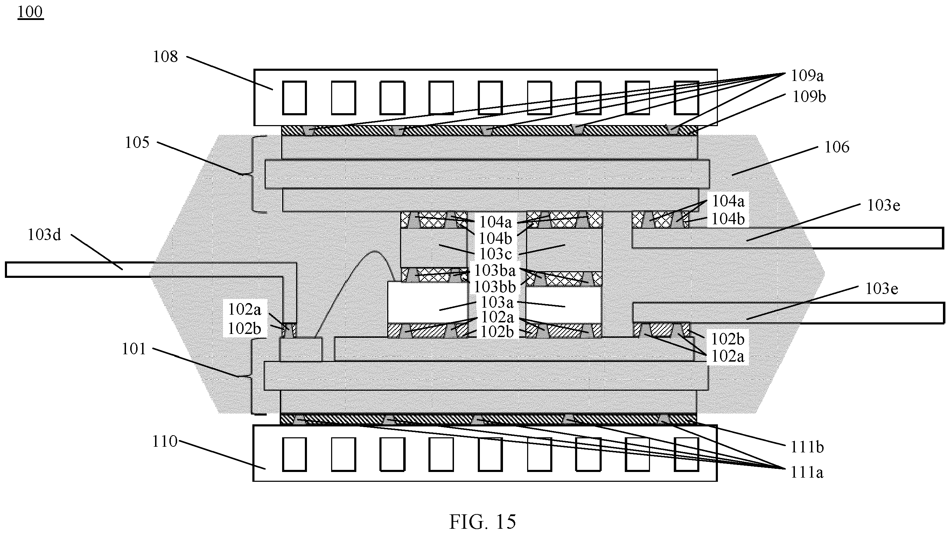

A person skilled in the art may understand that a high-integration and high-density packaging structure 100 has a quite high requirement on a heat dissipation effect. Based on this, to further improve a cooling capability of the packaging structure 100, as shown in FIG. 14 and FIG. 15, the packaging structure 100 provided in this application may further include a first heat dissipation part 108 and a fourth bonding layer 109.

Quantities of first heat dissipation parts 108 and fourth bonding layers 109 are not limited in this application, and one first heat dissipation part 108 corresponds to one or more fourth bonding layers 109. For ease of description, one first heat dissipation part 108 and one fourth bonding layer 109 are used for illustration in FIG. 14 and FIG. 15. FIG. 14 illustrates the packaging structure 100 based on the embodiment shown in FIG. 9, and FIG. 15 illustrates the packaging structure 100 based on the embodiment shown in FIG. 10.

In this application, the fourth bonding layer 109 is located between the first conductive surface (namely, the second conductive layer) of the first substrate 101 and the first heat dissipation part 108, and the fourth bonding layer 109 is configured to implement bonding between the first substrate 101 and the first heat dissipation part 108. The fourth bonding layer 109 may include a fourth bonding material 109b and at least one fourth support part 109a. For ease of description, one fourth bonding layer 109 uses five fourth support parts 109a for illustration in FIG. 14 and FIG. 15.

A specific type of the fourth bonding material 109b may be set based on a bonding manner, and is not limited in this application. Optionally, when a type of the fourth bonding layer 109 includes a solder layer, the fourth bonding material 109b may include a soldering lug or solder paste. When the type of the fourth bonding layer 109 includes a sintering layer, the fourth bonding material 109b may include a powdered material or a paste material. When the type of the fourth bonding layer 109 includes a solder layer and a sintering layer, the fourth bonding material 109b in the solder layer may include a soldering lug or solder paste, and the fourth bonding material 109b in the sintering layer may include a powdered material or a paste material.

The fourth support part 109a may be set to a micrometer-scale size, that is, a size of the fourth support part 109a in each dimension is at a micrometer scale. Because the size of the fourth support part 109a in each dimension is at a micrometer scale, compared with a volume of the fourth bonding layer 109 with a size of several millimeters, the size of the fourth support part 109a is quite small, so that the fourth support part 109a has quite small impact on a process of the fourth bonding layer 109 during bonding, and does not prevent a bubble formed on the fourth bonding layer 109 from escaping from the fourth bonding material 109b. This avoids an excessively high void ratio of the fourth bonding layer 109, and therefore has small impact on bonding of the fourth bonding layer 109, to avoid a reduction of a bonding effect between the second conductive surface of the first substrate 101 and the first heat dissipation part 108 that is caused by an excessively large size of the at least one fourth support part 109a, so that the first substrate 101 and the first heat dissipation part 108 can be reliably bonded.

Optionally, fourth support parts 109a in different fourth bonding layers 109 may have a same shape or different shapes. A plurality of fourth support parts 109a in a same fourth bonding layer 109 may have a same shape or different shapes. A shape of the fourth support part 109a is not limited in this application. Optionally, the shape of the fourth support part 109a includes at least one of a spherical shape, a rectangular shape, an ellipsoid shape, a wedge shape, or a silkworm shape.

Optionally, fourth support parts 109a in different fourth bonding layers 109 may have a same material or different materials. A plurality of fourth support parts 109a in a same fourth bonding layer 109 may have a same material or different materials. A material of the fourth support part 109a is not limited in this application. Optionally, the fourth support part 109a is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the forth support part 109a is any one of a covering material, a coating material, a strip material, and a wire material, for example, a metal coating or a heterogeneous metal covering. Therefore, manufacturing costs of the packaging structure 100 are reduced.

Optionally, there may be a same quantity or different quantities of fourth support parts 109a in different fourth bonding layers 109. A quantity of fourth support parts 109a in any fourth bonding layer 109 is not limited in this application. Therefore, the quantity of fourth support parts 109a in the forth bonding layer 109 is adjustable. Generally, the quantity of fourth support parts 109a may be greater than or equal to 3, to further improve a bonding effect of the fourth bonding layer 109 and ensure a support balance between the first substrate 101 and the first heat dissipation part 108. Optionally, fourth support parts 109a in different fourth bonding layers 109 may have a same position or different positions. A position of a fourth support part 109a in any fourth bonding layer 109 is not limited in this application. Therefore, the position of the fourth support part 109a in the fourth bonding layer 109 is flexible, so that a fourth support part 109a of a required size is implanted at a required position.

In this application, to prevent the fourth support part 109a from being melted by the fourth bonding material 109b and prevent a solder from moving to the outside of the fourth bonding layer 109 during bonding, the fourth support part 109a may be fastening. Further, because the fourth support part 109a has small impact on bonding of the fourth bonding layer 109, the fourth support part 109a may have a plurality of disposing positions, the operation is convenient and quick, and generation efficiency is high.

Optionally, the at least one fourth support part 109a may be fastening on the second conductive surface of the first substrate 101.

Optionally, the at least one fourth support part 109a may be fastening on a side that is of the first heat dissipation part 108 and that is close to the first substrate 101.

Optionally, the at least one fourth support part 109a may be fastening on the second conductive surface of the first substrate 101 and a side that is of the first heat dissipation part 108 and that is close to the first substrate 101, and fourth support parts 109a on the second conductive surface of the first substrate 101 and fourth support parts 109a on the side that is of the first heat dissipation part 108 and that is close to the first substrate 101 are alternately disposed.

A manner of fastening the fourth support part 109a is not limited in this application. Optionally, the fourth support part 109a is fastening in any one of the following manners: an ultrasonic wave, sintering, electroplating, or brazing.

In this application, a height of the at least one fourth support part 109a is the same as a thickness of the fourth bonding layer 109, and a melting point of the at least one fourth support part 109a is higher than a maximum temperature at which the fourth bonding layer 109 is formed. The thickness of the fourth bonding layer 109 may be set based on an actual case, and is not limited in this application. The height of the fourth support part 109a may be set based on a thickness of a corresponding fourth bonding layer 109, and a specific value of the height of the fourth support part 109a is not limited. Optionally, fourth support parts 109a in different fourth bonding layers 109 may have a same height or different heights.

Based on the foregoing setting, in a process of forming the fourth bonding layer 109, the at least one fourth support part 109a does not completely dissolve in the fourth bonding material 109b in the fourth bonding layer 109, so that the thickness of the at least one fourth support part 109a remains the same as the thickness of the fourth bonding layer 109, and the fourth bonding layer 109 with the height of the at least one fourth support part 109a is formed by using the at least one fourth support part 109a. In addition, when a plurality of times of reflow are required for the packaging structure 100, the at least one fourth support part 109a does not move with movement of the fourth bonding material 109b, so that the at least one fourth support part 109a is evenly distributed in the fourth bonding layer 109, and based on a support function of the at least one fourth support part 109a, the fourth bonding layer 109 can withstand extrusion without deformation, and the fourth bonding material 109b in the fourth bonding layer 109 does not overflow even if the at least one fourth support part 109a is remelted, thereby ensuring good quality and bonding strength of the fourth bonding layer 109. In this way, it is ensured that the fourth bonding layer 109 has a flat surface and a uniform thickness, and process requirements for the thickness and warpage of the fourth bonding layer 109 are met. In addition, unlimited types of the fourth bonding material 109b in the fourth bonding layer 109 facilitate manufacturing of the fourth bonding layer 109, and reduce costs of the fourth bonding layer 109.

Therefore, based on the flat surface and the uniform thickness of the fourth bonding layer 109, a good bonding effect is implemented between the first substrate 101 and the first heat dissipation part 108 by using the fourth bonding layer 109, so that reliability and a cooling capability of the packaging structure 100 are improved, and bonding costs are further reduced, thereby facilitating high density and high integration of the packaging structure 100.

Further with reference to FIG. 14 and FIG. 15, the packaging structure 100 provided in this application may further include a second heat dissipation part 110 and a fifth bonding layer 111. Quantities of second heat dissipation parts 110 and fifth bonding layers 111 are not limited in this application, and one second heat dissipation part 110 corresponds to one or more fifth bonding layers 111. For ease of description, one second heat dissipation part 110 and one fifth bonding layer 111 are used for illustration in FIG. 14 and FIG. 15.

In this application, the fifth bonding layer 111 is located between the second conductive surface (namely, the fourth conductive layer) of the second substrate 105 and the second heat dissipation part 110, and the fifth bonding layer 111 is configured to implement bonding between the second substrate 105 and the second heat dissipation part 110. The fifth bonding layer 111 may include a fifth bonding material 111b and at least one fifth support part 111a. For ease of description, one fifth bonding layer 111 uses five fifth support parts 111a for illustration in FIG. 14 and FIG. 15.

A specific type of the fifth bonding material 111b may be set based on a bonding manner, and is not limited in this application. Optionally, when a type of the fifth bonding layer 111 includes a solder layer, the fifth bonding material 111b may include a soldering lug or solder paste. When the type of the fifth bonding layer 111 includes a sintering layer, the fifth bonding material 111b may include a powdered material or a paste material. When the type of the fifth bonding layer 111 includes a solder layer and a sintering layer, the fifth bonding material 111b in the solder layer may include a soldering lug or solder paste, and the fifth bonding material 111b in the sintering layer may include a powdered material or a paste material.

The fifth support part 111a may be set to a micrometer-scale size, that is, a size of the fifth support part 111a in each dimension is at a micrometer scale. Because the size of the fifth support part 111a in each dimension is at a micrometer scale, compared with a volume of the fifth bonding layer 111 with a size of several millimeters, the size of the fifth support part 111a is quite small, so that the fifth support part 111a has quite small impact on a process of the fifth bonding layer 111 during bonding, and does not prevent a bubble formed on the fifth bonding layer 111 from escaping from the fifth bonding material 111b. This avoids an excessively high void ratio of the fifth bonding layer 111, and therefore has small impact on bonding of the fifth bonding layer 111, to avoid a reduction of a bonding effect between the second conductive surface of the second substrate 105 and the second heat dissipation part 110 that is caused by an excessively large size of the at least one fifth support part 111a, so that the second substrate 105 and the second heat dissipation part 110 can be reliably bonded.

Optionally, fifth support parts 111a in different fifth bonding layers 111 may have a same shape or different shapes; and/or a plurality of fifth support parts 111a in a same fifth bonding layer 111 may have a same shape or different shapes. A shape of the fifth support part 111a is not limited in this application. Optionally, the shape of the fifth support part 111a includes at least one of a spherical shape, a rectangular shape, an ellipsoid shape, a wedge shape, or a silkworm shape.

Optionally, fifth support parts 111a in different fifth bonding layers 111 may have a same material or different materials; and/or a plurality of fifth support parts 111a in a same fifth bonding layer 111 may have a same material or different materials. A material of the fifth support part 111a is not limited in this application. Optionally, the fifth support part 111a is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the fifth support part 111a is any one of a covering material, a coating material, a strip material, and a wire material, for example, a metal coating or a heterogeneous metal covering. Therefore, manufacturing costs of the packaging structure 100 are reduced.

Optionally, there may be a same quantity or different quantities of fifth support parts 111a in different fifth bonding layers 111. A quantity of fifth support parts 111a in any fifth bonding layer 111 is not limited in this application. Therefore, the quantity of fifth support parts 111a in the fifth bonding layer 111 is adjustable. Generally, the quantity of fifth support parts 111a may be greater than or equal to 3, to further improve a bonding effect of the fifth bonding layer 111 and ensure a support balance between the second substrate 105 and the second heat dissipation part 110.

Optionally, fifth support parts 111a in different fifth bonding layers 111 may have a same position or different positions. A position of a fifth support part 111a in any fifth bonding layer 111 is not limited in this application. Therefore, the position of the fifth support part 111a in the fifth bonding layer 111 is flexible, so that a fifth support part 111a of a required size is implanted at a required position.

In this application, to prevent the fifth support part 111a from being melted by the fifth bonding material 111b and prevent a solder from moving to the outside of the fifth bonding layer 111 during bonding, the fifth support part 111a may be fastening. Further, because the fifth support part 111a has small impact on bonding of the fifth bonding layer 111, the fifth support part 111a may have a plurality of disposing positions, the operation is convenient and quick, and generation efficiency is high.

Optionally, the at least one fifth support part 111a is fastening on a side that is of the second heat dissipation part 110 and that is close to the second substrate 105.

Optionally, the at least one fifth support part 111a is fastening on the second conductive surface of the second substrate 105.

Optionally, the at least one fifth support part 111a may be fastening on a side that is of the second heat dissipation part 110 and that is close to the second substrate 105 and the second conductive surface of the second substrate 105, and fifth support parts 111a on the side that is of the second heat dissipation part 110 and that is close to the second substrate 105 and fifth support parts 111a on the second conductive surface of the second substrate 105 are alternately disposed.

A manner of fastening the fifth support part 111a is not limited in this application. Optionally, the fifth support part 111a is fastening in any one of the following manners: an ultrasonic wave, sintering, electroplating, or brazing.

In this application, a height of the at least one fifth support part 111a is the same as a thickness of the fifth bonding layer 111, and a melting point of the at least one fifth support part 111a is higher than a maximum temperature at which the fifth bonding layer 111 is formed. The thickness of the fifth bonding layer 111 may be set based on an actual case, and is not limited in this application. The height of the fifth support part 111a may be set based on a thickness of a corresponding fifth bonding layer 111, and a specific value of the height of the fifth support part 111a is not limited. Optionally, fifth support parts 111a in different fifth bonding layers 111 may have a same height or different heights.

Based on the foregoing setting, in a process of forming the fifth bonding layer 111, the at least one fifth support part 111a does not completely dissolve in the fifth bonding material 111b in the fifth bonding layer 111, so that the thickness of the at least one fifth support part 111a remains the same as the thickness of the fifth bonding layer 111, and the fifth bonding layer 111 with the height of the at least one fifth support part 111a is formed by using the at least one fifth support part 111a. In addition, when a plurality of times of reflow are required for the packaging structure 100, the at least one fifth support part 111a does not move with movement of the fifth bonding material 111b, so that the at least one fifth support part 111a is evenly distributed in the fifth bonding layer 111, and based on a support function of the at least one fifth support part 111a, the fifth bonding layer 111 can withstand extrusion without deformation, and the fifth bonding material 111b in the fifth bonding layer 111 does not overflow even if the at least one fifth support part 111a is remelted, thereby ensuring good quality of the fifth bonding layer 111. In this way, it is ensured that the fifth bonding layer 111 has a flat surface and a uniform thickness, and process requirements for the thickness and warpage of the fifth bonding layer 111 are met. In addition, unlimited types of the fifth bonding material 111b in the fifth bonding layer 111 facilitate manufacturing of the fifth bonding layer 111, and reduce costs of the fifth bonding layer 111.

Therefore, based on the flat surface and the uniform thickness of the fifth bonding layer 111, a good bonding effect is implemented between the second substrate 105 and the second heat dissipation part 110 by using the fifth bonding layer 111, so that reliability and a cooling capability of the packaging structure 100 are improved, and bonding costs are further reduced, thereby facilitating high density and high integration of the packaging structure 100.

It should be noted that, according to the packaging structure 100 in this application, the first heat dissipation part 108 may be bonded to the second conductive surface of the first substrate 101, or the second heat dissipation part 110 may be bonded to the second conductive surface of the second substrate 105, or the first heat dissipation part 108 may be bonded to the second conductive surface of the first substrate 101 and the second heat dissipation part 110 may be bonded to the second conductive surface of the second substrate 105, and this is not limited in this application.

In addition, in this application, the first heat dissipation part 108 and/or the second heat dissipation part 110 may be separately disposed in the packaging structure 100 shown in FIG. 2 to FIG. 13. For a specific setting process, refer to description content in the embodiments shown in FIG. 14 and FIG. 15. A heat dissipation part may be jointly disposed in a plurality of packaging structures 100 shown in FIG. 2 to FIG. 13, to reduce costs. To be specific, a heat dissipation part is disposed on one side of the plurality of packaging structures 100, or a heat dissipation part is disposed on both sides of the plurality of packaging structures 100.

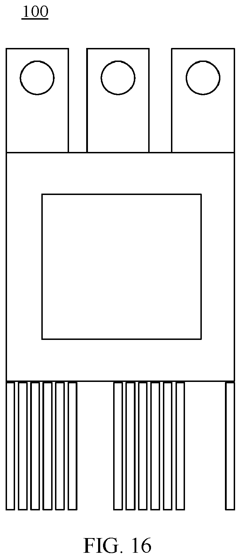

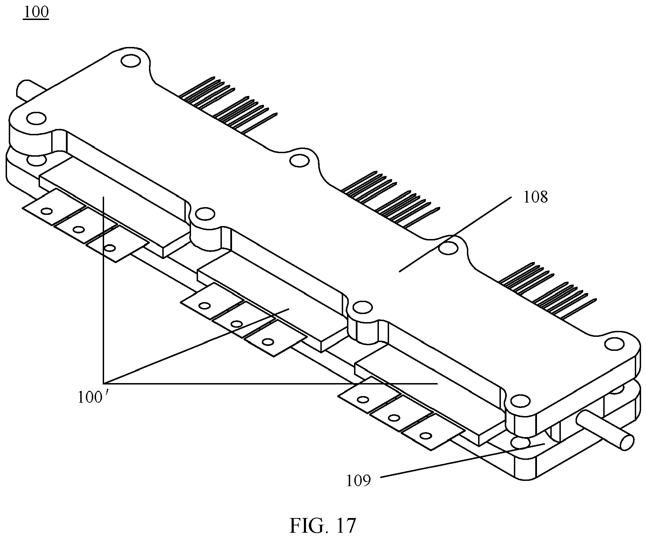

In a specific embodiment, the packaging structure 100 shown in FIG. 2 to FIG. 13 uses a direct current (direct current, DC) alternating current (alternating current, AC) conversion module 100' shown in FIG. 16 as an example. The DCAC conversion module 100' usually provides a three-phase alternating current to a device to which power is supplied. Therefore, in an actual use process, three DCAC conversion modules are often used. Based on this, to further improve a heat dissipation effect of the packaging structure 100, as shown in FIG. 17, the first heat dissipation part 108 may be disposed on one side of three DCAC conversion modules 100', and the second heat dissipation part 110 may be disposed on the other side of the three DCAC conversion modules 100', so that a complete packaging structure 100 is formed.

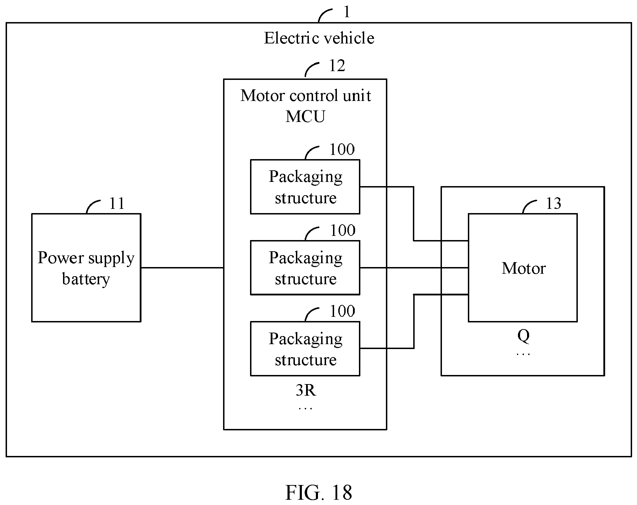

For example, this application further provides an electric vehicle. FIG. 18 is a schematic diagram of a structure of an electric vehicle according to an embodiment of this application. As shown in FIG. 18, an electric vehicle 1 provided in this application may include a power supply battery, a motor control unit (motor control unit, MCU) 12, and Q motors 13 (one motor 13 is used for illustration in FIG. 18), where Q is a positive integer.

The motor control unit MCU 12 may include 3R packaging structures 100 shown in FIG. 2 to FIG. 17 (three packaging structures 100 are used for illustration in FIG. 18), where R is a positive integer. The power supply battery may provide first electric energy for each packaging structure 100, and each motor 13 is correspondingly connected to at least three packaging structures 100 (one motor 13 is electrically connected to three packaging structures 100 for illustration in FIG. 18).

In this application, for any one of the 3R packaging structures 100, the motor control unit MCU 12 may control the packaging structure 100 to convert the first electric energy into second electric energy required by a motor 13 correspondingly connected to the packaging structure 100, and control the packaging structure 100 to transmit the second electric energy to the motor 13 correspondingly connected to the packaging structure 100, so that the correspondingly connected motor 13 can drive the electric vehicle 1.

Generally, the electric vehicle 1 usually uses an alternating current motor 13. Therefore, in this application, the first electric energy is usually a direct current, and the second electric energy is usually an alternating current. Generally, the alternating current includes at least a three-phase current. Therefore, each motor 13 is electrically connected to at least three packaging structures 100. Specific magnitudes of the first electric energy and the second electric energy are not limited in this application. In addition, a specific structure of the motor control unit MCU 12 is not limited in this application. The motor control unit MCU 12 may further include another component such as a switch control module.

It should be noted that, in addition to the foregoing connection manner, each motor may be electrically connected to at least one packaging structure 100, and this is not limited in this application.

The electric vehicle 1 provided in this application includes the packaging structure 100, and may execute the technical solutions in the embodiments of the packaging structure 100. For a specific implementation principle and technical effect of the electric vehicle 1, refer to the technical solutions of the foregoing embodiments shown in FIG. 2 to FIG. 17. Details are not described herein again.

For example, this application further provides an electronic apparatus. The electronic apparatus provided in this application may include at least one bonded structure. There may be one or more bonded structures, and this is not limited in this application. When the electronic apparatus includes a plurality of bonded structures, the plurality of bonded structures may be separately disposed, or may be stacked. This is not limited in this application.

For any one of the at least one bonded structure, the bonded structure may include a bonded component and at least one support part of a micrometer-scale size. The at least one support part is disposed on at least one to-be-bonded surface of the bonded part. In addition, a size of the support part in each dimension is at a micrometer scale. Because the size of the support part in each dimension is at a micrometer scale, the size of the support part is quite small compared with a volume of a bonding layer with a size of several millimeters, so that the support part has small impact on a process of the bonding layer during bonding, and does not prevent a bubble formed on the bonding layer from escaping from a bonding material. This avoids an excessively high void rate of the bonding layer, and therefore has small impact on bonding of the bonding layer, to avoid a reduction of a bonding effect of the bonded part that is caused by an excessively large size of the at least one support part, so that the bonded part and another component can be reliably bonded.

In other words, the bonded part may include one to-be-bonded surface, or may include a plurality of to-be-bonded surfaces. A specific quantity may be set based on an actual bonding status.

When the bonded part includes one to-be-bonded surface, one support part may be disposed on the to-be-bonded surface, a height of the support part is the same as a thickness of a bonding layer, the bonding layer includes the support part and a bonding material, and a melting point of the support part is higher than a maximum temperature at which the bonding layer is formed.

When the bonded part includes one to-be-bonded surface, a plurality of support parts may be disposed on the to-be-bonded surface, a height of each support part remains the same as a thickness of a bonding layer, the bonding layer includes each support part and a bonding material, and a melting point of each support part is higher than a maximum temperature at which the bonding layer is formed. Melting points of all the support parts may be the same or different, provided that a lowest melting point of a support part among all the support parts is higher than the highest temperature at which the bonding layer is formed.

When the bonded part includes a plurality of to-be-bonded surfaces, one support part may be disposed on each to-be-bonded surface, a thickness of a support part on any to-be-bonded surface is the same as a thickness of a bonding layer, the bonding layer includes the support part and a bonding material, and a melting point of the support part is higher than a maximum temperature at which the bonding layer is formed.

When the bonded part includes a plurality of to-be-bonded surfaces, a plurality of support parts may be disposed on each to-be-bonded surface, a thickness of each support part on a same to-be-bonded surface remains the same as a thickness of a bonding layer, the bonding layer includes each support part on the to-be-bonded surface and a bonding material, and a melting point of each support part is higher than a maximum temperature at which the bonding layer is formed. Melting points of all the support parts may be the same or different, provided that a lowest melting point of a support part among all the support parts is higher than the maximum temperature at which the bonding layer is formed.

In this application, a specific type of the bonding material is not limited in this application. Optionally, when a type of the bonding layer includes a solder layer, the bonding material may include a soldering lug or solder paste. When the type of the bonding layer includes a sintering layer, the bonding material may include a powdered material or a paste material. When the type of the bonding layer includes a solder layer and a sintering layer, the bonding material in the solder layer may include a soldering lug or solder paste, and the bonding material in the sintering layer may include a powdered material or a paste material.

In this application, support parts in different bonding layers may have a same shape or different shapes. A plurality of support parts in a same bonding layer may have a same shape or different shapes. A shape of the support part is not limited in this application. Optionally, the shape of the support part includes at least one of a spherical shape, a rectangular shape, an ellipsoid shape, a wedge shape, or a silkworm shape.

In this application, support parts in different bonding layers may have a same material or different materials; and/or a plurality of support parts in a same bonding layer may have a same material or different materials. A material of the support part is not limited in this application. Optionally, the support part is any one of a single-metal material, an alloy material, a composite material, or a non-conductive material. For example, the single-metal material may include aluminum Al, gold Au, copper Cu, or nickel Ni. The alloy material may include at least two of aluminum Al, gold Au, copper Cu, or nickel Ni. Optionally, the support part may be any one of a covering material, a coating material, a strip material, and a wire material, for example, a metal coating or a heterogeneous metal covering. Therefore, manufacturing costs of the electronic apparatus are reduced.

In this application, support parts in different bonding layers may have a same height or different heights. A height of the support part may be set based on a thickness of a corresponding bonding layer, and a specific value of the height of the support part is not limited.

In this application, there may be a same quantity or different quantities of support parts in different bonding layers. A quantity of support parts is not limited in this application. In addition, a quantity of support parts in any bonding layer is not limited, either. Therefore, a quantity of support parts in the bonding layer is adjustable. Generally, the quantity of support parts may be greater than or equal to 3, to further improve a bonding effect of the bonding layer and ensure a support balance of a bonded part.

In this application, support parts in different bonding layers may have a same position or different positions. A position of the support part is not limited in this application. In addition, a position of a support part in any bonding layer is not limited, either. Therefore, the position of the support part in the bonding layer is flexible, so that a support part of a required size is implanted at a required position.

In addition, a manner of fastening the support part to the to-be-bonded surface of the bonded part is not limited in this application. Optionally, the support part is fastening in any one of the following manners: an ultrasonic wave, sintering, electroplating, or brazing.

In this application, to prevent the support part from being melted by a bonding material and prevent a solder from moving to the outside of a bonding layer, the support part may be fastening. Further, because the support part has small impact on bonding of the bonding layer, the support part may have a plurality of disposing positions, the operation is convenient and quick, and generation efficiency is high. A specific type of the bonded part is not limited in this application. Optionally, the type of the bonded part includes at least one of a chip, an interconnection column, an insulating substrate, a resistor, a capacitor, an inductor, a sensor, a terminal, or a heat dissipation plate.

Based on the foregoing description, in a process in which any to-be-bonded surface of the bonded part is bonded to another component, because a support part of a micrometer-scale size is disposed on the to-be-bonded surface of the bonded part, a height of the support part is the same as a thickness of a bonding layer, and a melting point of the support part is higher than a maximum temperature at which the bonding layer is formed, the support part does not completely dissolve in a bonding material in the bonding layer, so that the thickness of the support part remains the same as the thickness of the bonding layer, and the bonding layer with the same height as the support part is formed by using the support part. In addition, when a plurality of times of reflow are required for the electronic apparatus, the support part does not move with movement of the bonding material, so that the support part is evenly distributed in the bonding layer, and based on a support function of the support part, the bonding layer can withstand extrusion without deformation, and the bonding material in the bonding layer does not overflow even if the support part is remelted, thereby ensuring good quality and bonding strength of the bonding layer, and avoiding a phenomenon such as electrical short-circuiting or a failure of the electronic apparatus that is caused by insufficiency of the bonding material below the bonded part. In this way, it is ensured that the bonding layer has a flat surface and a uniform thickness, and process requirements for the thickness and warpage of the bonding layer are met. In addition, unlimited types of the bonding material in the bonding layer facilitate manufacturing of the bonding layer, and reduce manufacturing costs of the bonding layer. Therefore, reliability of the electronic apparatus is improved, and manufacturing costs of the electronic apparatus are reduced.

A specific type of the electronic apparatus is not limited in this application. Optionally, the electronic apparatus may include a three-dimensional 3D packaging module such as a semiconductor power module or a laminated module of a printed circuit board PCB.

According to the electronic apparatus provided in this application, the at least one bonded structure includes the bonded part and the at least one support part of the micrometer-scale size, and the at least one support part is disposed on the at least one to-be-bonded surface of the bonded part. For a support part on any to-be-bonded surface of the bonded part, a height of the support part is the same as a thickness of a bonding layer, the support part and a bonding material form the bonding layer, and a melting point of the support part is higher than a maximum temperature at which the bonding layer is formed, so that the bonding layer has a flat surface and a uniform thickness. Therefore, in a bonding process of the bonded part, because the support part of the micrometer-scale size is disposed on the to-be-bonded surface of the bonded part, the height of the support part is the same as the thickness of the bonding layer, and the melting point of the support part is higher than the maximum temperature at which the bonding layer is formed, the support part does not completely dissolve in the bonding material in the bonding layer, so that the thickness of the support part remains the same as the thickness of the bonding layer, and the bonding layer with the same height as the support part is formed by using the support part. In addition, when a plurality of times of reflow are required for the electronic apparatus, the support part does not move with movement of the bonding material, so that the support part is evenly distributed in the bonding layer, and based on a support function of the support part, the bonding layer can withstand extrusion without deformation, and the bonding material in the bonding layer does not overflow even if the support part is remelted, thereby ensuring good quality and bonding strength of the bonding layer, and avoiding a phenomenon such as electrical short-circuiting or a failure of the electronic apparatus that is caused by insufficiency of the bonding material below the bonded part. In this way, it is ensured that the bonding layer has a flat surface and a uniform thickness, and process requirements for the thickness and warpage of the bonding layer are met. In addition, unlimited types of the bonding material in the bonding layer facilitate manufacturing of the bonding layer, and reduce manufacturing costs of the bonding layer. Therefore, reliability of the electronic apparatus is improved, and manufacturing costs of the electronic apparatus are reduced.

The foregoing descriptions are merely specific implementations of this application, but are not intended to limit the protection scope of this application. Any variation or replacement readily figured out by a person skilled in the art within the technical scope disclosed in the present invention shall fall within the protection scope of this application. Therefore, the protection scope of this application shall be subject to the protection scope of the claims.

## Claims

1. A packaging structure (100), comprising a first substrate (101), a first bonding layer (102), an electronic element (103), a second bonding layer (104), and a second substrate (105), wherein
the first bonding layer (102) is located between a first conductive surface of the first substrate (101) and a first bonding surface of the electronic element (103), and the first bonding layer (102) is configured to implement bonding between the electronic element (103) and the first substrate (101);
the first bonding layer (102) comprises a first bonding material (102b) and at least one first support part (102a), a height of the at least one first support part (102a) is the same as a thickness of the first bonding layer (102), and a melting point of the at least one first support part (102a) is higher than a maximum temperature at which the first bonding layer (102) is formed, so that the first bonding layer (102) has a flat surface and a uniform thickness; and
the second bonding layer (104) is located between a second bonding surface of the electronic element (103) and a first conductive surface of the second substrate (105), the second bonding layer (104) is configured to implement bonding between the electronic element (103) and the second substrate (105), and the first bonding surface of the electronic element (103) is opposite to the second bonding surface of the electronic element (103);
wherein:
a plurality of unconnected first bonding layers (102) and a plurality of unconnected second bonding layers (104) are comprised, the electronic element (103) comprises a chip (103a), a signal terminal (103d), and a power terminal (103e);
the chip (103a) is located between a first bonding layer (102) other than a first bonding layer corresponding to the signal terminal (103d) and a first bonding layer (1032) corresponding to the power terminal (103e) and a corresponding second bonding layer (104);
the signal terminal (103d) is disposed extending from the inside of the packaging structure (100) to the outside of the packaging structure (100), an end of the signal terminal (103d) that is located inside the packaging structure (100) is located on a first bonding layer (102) other than a first bonding layer (102) corresponding to the chip (103a) and the first bonding layer (102) corresponding to the power terminal (103e), the first bonding layer (102) comprises a first bonding material (102b) and a first support part (102a) that is fastening on the first conductive surface of the first substrate (101), the signal terminal (103d) is electrically connected to the chip (103a), and the first bonding layer (102) corresponding to the chip (103a) and the first bonding layer (102) corresponding to the signal terminal (103d) correspond to different conductive areas in the first conductive surface of the first substrate (101); and
the power terminal (103e) is disposed extending from the inside of the packaging structure (100) to the outside of the packaging structure (100), an end of the power terminal (103e) that is located inside the packaging structure (100) is located on a first bonding layer (102) other than the first bonding layer (102) corresponding to the chip (103a) and the first bonding layer (102) corresponding to the signal terminal (103d), the first bonding layer (102) comprises a first bonding material (102b) and a first support part (102a) that is fastening on the first conductive surface of the first substrate (101), and the first bonding layer (102) corresponding to the chip (103a) and the first bonding layer (102) corresponding to the power terminal (103e) correspond to a same conductive area in the first conductive surface of the first substrate (101); and/or the power terminal (103e) is located on a second bonding layer (104) other than a second bonding layer (104) corresponding to the chip (103a), the second bonding layer (104) comprises a second bonding material (104b) and a second support part (104a) that is fastening on the first conductive surface of the second substrate (105), and the second bonding layer (104) corresponding to the chip (103a) and a second bonding layer (104) corresponding to the power terminal (103e) correspond to a same conductive area in the first conductive surface of the second substrate (105).

2. The packaging structure (100) according to claim 1, wherein
the second bonding layer (104) comprises a second bonding material (104b) and at least one second support part (104a), a height of the at least one second support part (104a) is the same as a thickness of the second bonding layer (104), and a melting point of the at least one second support part (104a) is higher than a maximum temperature at which the second bonding layer (104) is formed, so that the second bonding layer (104) has a flat surface and a uniform thickness.

3. The packaging structure (100) according to claim 2, wherein
the at least one second support part (104a) is fastening on the second bonding surface of the electronic element (103) or the first conductive surface of the second substrate (105).

4. The packaging structure (100) according to any one of claims 1 to 3, wherein the packaging structure (100) further comprises a plastic packaging material (106); and the first substrate (101), the first bonding layer (102), a part of the electronic element (103), the second bonding layer (104), and the second substrate (105) are all disposed in the plastic packaging material (106).

5. The packaging structure (100) according to any one of claims 1 to 4, wherein
the at least one first support part (102a) is fastening on the first bonding surface of the electronic element (103) or the first conductive surface of the first substrate (101).

6. The packaging structure (100) according to claim 1, wherein the electronic element (103) further comprises a sensor (107); and
both ends of the sensor (107) are separately located on first bonding layers (102) other than the first bonding layer (102) corresponding to the chip (103a), the first bonding layer (102) corresponding to the signal terminal (103d), and the first bonding layer (102) corresponding to the power terminal (103e), the first bonding layer (102) comprises a first bonding material (102b) and a first support part that is fastening on the first conductive surface of the first substrate (101), and the first bonding layer (102) corresponding to the chip (103a) and the two first bonding layers (102) corresponding to the sensor (107) correspond to different conductive areas in the first conductive surface of the first substrate (101); and/or
one end of the sensor (107) is located on a first bonding layer (102) other than the first bonding layer (102) corresponding to the chip (103a), the first bonding layer (102) corresponding to the signal terminal (103d), and the first bonding layer (102) corresponding to the power terminal (103e), the first bonding layer (102) comprises a first bonding material (102b) and a first support part that is fastening on the first conductive surface of the first substrate (101), the other end of the sensor (107) is disposed extending from the inside of the packaging structure to the outside of the packaging structure through a transmission wire, and the first bonding layer (102) corresponding to the chip (103a) and the first bonding layer (102) corresponding to the sensor (107) correspond to different conductive areas in the first conductive surface of the first substrate (101).

7. The packaging structure (100) according to any one of claims 1 to 6, wherein the packaging structure (100) further comprises a first heat dissipation part (108) and a fourth bonding layer (109);
the fourth bonding layer (109) is located between a second conductive surface of the first substrate (101) and the first heat dissipation part (108), the second conductive surface of the first substrate (101) is exposed to the outside of the packaging structure (100), and the fourth bonding layer (109) is configured to implement bonding between the first substrate (101) and the first heat dissipation part (108); and
the fourth bonding layer (109) comprises a fourth bonding material (109b) and at least one fourth support part (109a), a height of the at least one fourth support part (109a) is the same as a thickness of the fourth bonding layer (109), and a melting point of the at least one fourth support part (109a) is higher than a maximum temperature at which the fourth bonding layer (109) is formed, so that the fourth bonding layer (109) has a flat surface and a uniform thickness.

8. The packaging structure (100) according to claim 7, wherein
the at least one fourth support part (109a) is fastening on the second conductive surface of the first substrate (101) or a side that is of the first heat dissipation part (108) and that is close to the first substrate (101).

9. The packaging structure (100) according to any one of claims 1 to 8, wherein the packaging structure further comprises a second heat dissipation part (110) and a fifth bonding layer (111);
the fifth bonding layer (111) is located between a second conductive surface of the second substrate (105) and the second heat dissipation part (110), the second conductive surface of the second substrate (105) is exposed to the outside of the packaging structure (100), and the fifth bonding layer (111) is configured to implement bonding between the second substrate (105) and the second heat dissipation part (110); and
the fifth bonding layer (111) comprises a fifth bonding material (111b) and at least one fifth support part (111a), a height of the at least one fifth support part (111a) is the same as a thickness of the fifth bonding layer (111), and a melting point of the at least one fifth support part (111a) is higher than a maximum temperature at which the fifth bonding layer (111) is formed, so that the fifth bonding layer (111) has a flat surface and a uniform thickness.

10. The packaging structure (100) according to claim 9, wherein
the at least one fifth support part (111a) is fastening on the second conductive surface of the second substrate (105) or a side that is of the second heat dissipation part (110) and that is close to the second substrate (105).

11. An electric vehicle (1), comprising a power supply battery (11), a motor control unit MCU (12), and Q motors (13), wherein Q is a positive integer;
the motor control unit MCU (12) comprises 3R packaging structures (100) according to any one of claims 1 to 10, R is a positive integer, the power supply battery (11) provides first electric energy for each packaging structure (100), and each motor (13) is correspondingly connected to at least three packaging structures (100); and
for any one of the 3R packaging structures (100), the motor control unit MCU (12) is configured to: control the packaging structure (100) to convert the first electric energy into second electric energy required by a motor (13) correspondingly connected to the packaging structure (100), and control the packaging structure(100) to transmit the second electric energy to the motor (13) correspondingly connected to the packaging structure (100).

## Patentansprüche

1. Verpackungsstruktur (100), die ein erstes Substrat (101), eine erste Verbindungsschicht (102), ein elektronisches Element (103), eine zweite Verbindungsschicht (104) und ein zweites Substrat (105) umfasst, wobei die erste Verbindungsschicht (102) sich zwischen einer ersten leitfähigen Oberfläche des ersten Substrats (101) und einer ersten Verbindungsoberfläche des elektronischen Elements (103) befindet, und die erste Verbindungsschicht (102) konfiguriert ist, um eine Verbindung zwischen dem elektronischen Element (103) und dem ersten Substrat (101) herzustellen;
die erste Verbindungsschicht (102) ein erstes Verbindungsmaterial (102b) und mindestens ein erstes Trägerteil (102a) umfasst, eine Höhe des mindestens einen ersten Trägerteils (102a) gleich einer Dicke der ersten Verbindungsschicht (102) ist, und ein Schmelzpunkt des mindestens einen ersten Trägerteils (102a) höher als eine Maximaltemperatur ist, bei der die erste Verbindungsschicht (102) gebildet wird, so dass die erste Verbindungsschicht (102) eine flache Oberfläche und eine gleichmäßige Dicke aufweist; und
die zweite Verbindungsschicht (104) sich zwischen einer zweiten Verbindungsoberfläche des elektronischen Elements (103) und einer ersten leitfähigen Oberfläche des zweiten Substrats (105) befindet, die zweite Verbindungsschicht (104) konfiguriert ist, um eine Verbindung zwischen dem elektronischen Element (103) und dem zweiten Substrat (105) herzustellen, und die erste Verbindungsoberfläche des elektronischen Elements (103) der zweiten Verbindungsoberfläche des elektronischen Elements (103) gegenüberliegt;
wobei:
eine Vielzahl von unverbundenen ersten Verbindungsschichten (102) und eine Vielzahl von unverbundenen zweiten Verbindungsschichten (104) umfasst sind, das elektronische Element (103) einen Chip (103a), einen Signalanschluss (103d) und einen Stromanschluss (103e) umfasst;
der Chip (103a) sich zwischen einer ersten Verbindungsschicht (102), die nicht eine erste Verbindungsschicht, die dem Signalanschluss (103d) entspricht, ist, und einer ersten Verbindungsschicht (1032), die dem Stromanschluss (103e) entspricht, und einer entsprechenden zweiten Verbindungsschicht (104) befindet;
der Signalanschluss (103d) so angeordnet ist, dass er sich von der Innenseite der Verpackungsstruktur (100) zu der Außenseite der Verpackungsstruktur (100) erstreckt, ein Ende des Signalanschlusses (103d), das sich innerhalb der Verpackungsstruktur (100) befindet, sich auf einer ersten Verbindungsschicht (102) befindet, die nicht die erste Verbindungsschicht (102), die dem Chip (103a) entspricht, und die erste Verbindungsschicht (102), die dem Stromanschluss (103e) entspricht, ist, die erste Verbindungsschicht (102) ein erstes Verbindungsmaterial (102b) und ein erstes Trägerteil (102a) umfasst, das an der ersten leitfähigen Oberfläche des ersten Substrats (101) befestigt ist, der Signalanschluss (103d) elektrisch mit dem Chip (103a) verbunden ist, und die erste Verbindungsschicht (102), die dem Chip (103a) entspricht, und die erste Verbindungsschicht (102), die dem Signalanschluss (103d) entspricht, unterschiedlichen leitfähigen Bereichen in der ersten leitfähigen Oberfläche des ersten Substrats (101) entsprechen; und
der Stromanschluss (103e) so angeordnet ist, dass er sich von der Innenseite der Verpackungsstruktur (100) zu der Außenseite der Verpackungsstruktur (100) erstreckt, ein Ende des Stromanschlusses (103e), das sich innerhalb der Verpackungsstruktur (100) befindet, sich auf einer ersten Verbindungsschicht (102) befindet, die nicht die erste Verbindungsschicht (102), die dem Chip (103a) entspricht, und die erste Verbindungsschicht (102), die dem Signalanschluss (103d) entspricht, ist, die erste Verbindungsschicht (102) ein erstes Verbindungsmaterial (102b) und ein erstes Trägerteil (102a) umfasst, das an der ersten leitfähigen Oberfläche des ersten Substrats (101) befestigt ist, und die erste Verbindungsschicht (102), die dem Chip (103a) entspricht, und die erste Verbindungsschicht (102), die dem Stromanschluss (103e) entspricht, einem gleichen leitfähigen Bereich in der ersten leitfähigen Oberfläche des ersten Substrats (101) entsprechen; und/oder der Stromanschluss (103e) sich auf einer zweiten Verbindungsschicht (104) befindet, die nicht eine zweite Verbindungsschicht (104), die dem Chip (103a) entspricht, ist, wobei die zweite Verbindungsschicht (104) ein zweites Verbindungsmaterial (104b) und ein zweites Trägerteil (104a) umfasst, das an der ersten leitfähigen Oberfläche des zweiten Substrats (105) befestigt ist, und wobei die zweite Verbindungsschicht (104), die dem Chip (103a) entspricht, und eine zweite Verbindungsschicht (104), die dem Stromanschluss (103e) entspricht, einem gleichen leitfähigen Bereich in der ersten leitfähigen Oberfläche des zweiten Substrats (105) entsprechen.

2. Verpackungsstruktur (100) nach Anspruch 1, wobei
die zweite Verbindungsschicht (104) ein zweites Verbindungsmaterial (104b) und mindestens ein zweites Trägerteil (104a) umfasst, eine Höhe des mindestens einen zweiten Trägerteils (104a) gleich einer Dicke der zweiten Verbindungsschicht (104) ist und ein Schmelzpunkt des mindestens einen zweiten Trägerteils (104a) höher als eine Maximaltemperatur ist, bei der die zweite Verbindungsschicht (104) gebildet wird, so dass die zweite Verbindungsschicht (104) eine flache Oberfläche und eine gleichmäßige Dicke aufweist.

3. Verpackungsstruktur (100) nach Anspruch 2, wobei
das mindestens eine zweite Trägerteil (104a) an der zweiten Verbindungsoberfläche des elektronischen Elements (103) oder der ersten leitfähigen Oberfläche des zweiten Substrats (105) befestigt ist.

4. Verpackungsstruktur (100) nach einem der Ansprüche 1 bis 3, wobei die Verpackungsstruktur (100) ferner ein Kunststoffverpackungsmaterial (106) umfasst; und das erste Substrat (101), die erste Verbindungsschicht (102), ein Teil des elektronischen Elements (103), die zweite Verbindungsschicht (104) und das zweite Substrat (105) alle in dem Kunststoffverpackungsmaterial (106) angeordnet sind.

5. Verpackungsstruktur (100) nach einem der Ansprüche 1 bis 4, wobei das mindestens eine erste Trägerteil (102a) an der ersten Verbindungsoberfläche des elektronischen Elements (103) oder der ersten leitfähigen Oberfläche des ersten Substrats (101) befestigt ist.

6. Verpackungsstruktur (100) nach Anspruch 1, wobei das elektronische Element (103) ferner einen Sensor (107) umfasst; und
beide Enden des Sensors (107) sich separat auf ersten Verbindungsschichten (102) befinden, die nicht die erste Verbindungsschicht (102), die dem Chip (103a) entspricht, die erste Verbindungsschicht (102), die dem Signalanschluss (103d) entspricht, und die erste Verbindungsschicht (102), die dem Stromanschluss (103e) entspricht, ist, wobei die erste Verbindungsschicht (102) ein erstes Verbindungsmaterial (102b) und ein erstes Trägerteil umfasst, das an der ersten leitfähigen Oberfläche des ersten Substrats (101) befestigt ist, und wobei die erste Verbindungsschicht (102), die dem Chip (103a) entspricht, und die beiden ersten Verbindungsschichten (102), die dem Sensor (107) entsprechen, unterschiedlichen leitfähigen Bereichen in der ersten leitfähigen Oberfläche des ersten Substrats (101) entsprechen; und/oder ein Ende des Sensors (107) sich auf einer ersten Verbindungsschicht (102) befindet, die nicht die erste Verbindungsschicht (102), die dem Chip (103a) entspricht, die erste Verbindungsschicht (102), die dem Signalanschluss (103d) entspricht, und die erste Verbindungsschicht (102), die dem Stromanschluss (103e) entspricht, ist, wobei die erste Verbindungsschicht (102) ein erstes Verbindungsmaterial (102b) und ein erstes Trägerteil umfasst, das an der ersten leitfähigen Oberfläche des ersten Substrats (101) befestigt ist, das andere Ende des Sensors (107) so angeordnet ist, dass es sich über einen Übertragungsdraht von der Innenseite der Verpackungsstruktur zu der Außenseite der Verpackungsstruktur erstreckt, und wobei die erste Verbindungsschicht (102), die dem Chip (103a) entspricht, und die erste Verbindungsschicht (102), die dem Sensor (107) entspricht, unterschiedlichen leitfähigen Bereichen in der ersten leitfähigen Oberfläche des ersten Substrats (101) entsprechen.

7. Verpackungsstruktur (100) nach einem der Ansprüche 1 bis 6, wobei die Verpackungsstruktur (100) ferner ein erstes Wärmeableitungsteil (108) und eine vierte Verbindungsschicht (109) umfasst;
die vierte Verbindungsschicht (109) sich zwischen einer zweiten leitfähigen Oberfläche des ersten Substrats (101) und dem ersten Wärmeableitungsteil (108) befindet, die zweite leitfähige Oberfläche des ersten Substrats (101) an der Außenseite der Verpackungsstruktur (100) freiliegt, und die vierte Verbindungsschicht (109) konfiguriert ist, um eine Verbindung zwischen dem ersten Substrat (101) und dem ersten Wärmeableitungsteil (108) herzustellen; und
die vierte Verbindungsschicht (109) ein viertes Verbindungsmaterial (109b) und mindestens ein viertes Trägerteil (109a) umfasst, eine Höhe des mindestens einen vierten Trägerteils (109a) gleich einer Dicke der vierten Verbindungsschicht (109) ist und ein Schmelzpunkt des mindestens einen vierten Trägerteils (109a) höher als eine Maximaltemperatur ist, bei der die vierte Verbindungsschicht (109) gebildet wird, so dass die vierte Verbindungsschicht (109) eine flache Oberfläche und eine gleichmäßige Dicke aufweist.

8. Verpackungsstruktur (100) nach Anspruch 7, wobei
das mindestens eine vierte Trägerteil (109a) an der zweiten leitfähigen Oberfläche des ersten Substrats (101) oder einer Seite des ersten Wärmeableitungsteils (108) befestigt ist, die nahe dem ersten Substrat (101) gelegen ist.

9. Verpackungsstruktur (100) nach einem der Ansprüche 1 bis 8, wobei die Verpackungsstruktur ferner einen zweiten Wärmeableitungsteil (110) und eine fünfte Verbindungsschicht (111) umfasst;
die fünfte Verbindungsschicht (111) sich zwischen einer zweiten leitfähigen Oberfläche des zweiten Substrats (105) und dem zweiten Wärmeableitungsteil (110) befindet, die zweite leitfähige Oberfläche des zweiten Substrats (105) an der Außenseite der Verpackungsstruktur (100) freiliegt, und die fünfte Verbindungsschicht (111) konfiguriert ist, um eine Verbindung zwischen dem zweiten Substrat (105) und dem zweiten Wärmeableitungsteil (110) herzustellen; und
die fünfte Verbindungsschicht (111) ein fünftes Verbindungsmaterial (111b) und mindestens ein fünftes Trägerteil (111a) umfasst, eine Höhe des mindestens einen fünften Trägerteils (111a) gleich einer Dicke der fünften Verbindungsschicht (111) ist und ein Schmelzpunkt des mindestens einen fünften Trägerteils (111a) höher als eine Maximaltemperatur ist, bei der die fünfte Verbindungsschicht (111) gebildet wird, so dass die fünfte Verbindungsschicht (111) eine flache Oberfläche und eine gleichmäßige Dicke aufweist.

10. Verpackungsstruktur (100) nach Anspruch 9, wobei
das mindestens eine fünfte Trägerteil (111a) an der zweiten leitfähigen Oberfläche des zweiten Substrats (105) oder einer Seite des zweiten Wärmeableitungsteils (110) befestigt ist, die nahe dem zweiten Substrat (105) gelegen ist.

11. Elektrofahrzeug (1), das eine Stromversorgungsbatterie (11), eine Motorsteuereinheit MCU (12) und Q Motoren (13) umfasst, wobei Q eine positive ganze Zahl ist;
die Motorsteuereinheit MCU (12) 3R Verpackungsstrukturen (100) nach einem der Ansprüche 1 bis 10 umfasst, R eine positive ganze Zahl ist, die Stromversorgungsbatterie (11) erste elektrische Energie für jede Verpackungsstruktur (100) liefert und jeder Motor (13) entsprechend mit mindestens drei Verpackungsstrukturen (100) verbunden ist; und
für jede der 3R Verpackungsstrukturen (100) die Motorsteuereinheit MCU (12) konfiguriert ist zum: Steuern der Verpackungsstruktur (100), um die erste elektrische Energie in zweite elektrische Energie umzuwandeln, die von einem entsprechend mit der Verpackungsstruktur (100) verbundenen Motor (13) benötigt wird, und Steuern der Verpackungsstruktur (100), um die zweite elektrische Energie an den entsprechend mit der Verpackungsstruktur (100) verbundenen Motor (13) zu übertragen.

## Revendications

1. Structure de conditionnement (100), comprenant un premier substrat (101), une première couche de liaison (102), un élément électronique (103), une deuxième couche de liaison (104) et un second substrat (105), dans laquelle
la première couche de liaison (102) est située entre une première surface conductrice du premier substrat (101) et une première surface de liaison de l'élément électronique (103), et la première couche de liaison (102) est configurée pour mettre en oeuvre une liaison entre l'élément électronique (103) et le premier substrat (101) ;
la première couche de liaison (102) comprend un premier matériau de liaison (102b) et au moins une première partie de support (102a), une hauteur de l'au moins une première partie de support (102a) est identique à une épaisseur de la première couche de liaison (102), et un point de fusion de l'au moins une première partie de support (102a) est supérieur à une température maximale à laquelle la première couche de liaison (102) est formée, de sorte que la première couche de liaison (102) a une surface plane et une épaisseur uniforme ; et
la deuxième couche de liaison (104) est située entre une seconde surface de liaison de l'élément électronique (103) et une première surface conductrice du second substrat (105), la deuxième couche de liaison (104) est configurée pour mettre en oeuvre une liaison entre l'élément électronique (103) et le second substrat (105), et la première surface de liaison de l'élément électronique (103) est opposée à la seconde surface de liaison de l'élément électronique (103) ;
dans laquelle :
une pluralité de premières couches de liaison non-connectées (102) et une pluralité de secondes couches de liaison non-connectées (104) sont comprises, l'élément électronique (103) comprend une puce (103a), une borne de signal (103d) et une borne d'alimentation (103e) ;
la puce (103a) est située entre une première couche de liaison (102) autre qu'une première couche de liaison correspondant à la borne de signal (103d) et une première couche de liaison (1032) correspondant à la borne d'alimentation (103e) et une deuxième couche de liaison correspondante (104) ;
la borne de signal (103d) s'étend de l'intérieur de la structure de conditionnement (100) à l'extérieur de la structure de conditionnement (100), une extrémité de la borne de signal (103d) située à l'intérieur de la structure de conditionnement (100) est située sur une première couche de liaison (102) autre qu'une première couche de liaison (102) correspondant à la puce (103a) et la première couche de liaison (102) correspondant à la borne d'alimentation (103e), la première couche de liaison (102) comprend un premier matériau de liaison (102b) et une première partie de support (102a) qui est fixée sur la première surface conductrice du premier substrat (101), la borne de signal (103d) est connectée électriquement à la puce (103a), et la première couche de liaison (102) correspondant à la puce (103a) et la première couche de liaison (102) correspondant à la borne de signal (103d) correspondent à des zones conductrices différentes dans la première surface conductrice du premier substrat (101) ; et
la borne d'alimentation (103e) s'étend de l'intérieur de la structure de conditionnement (100) à l'extérieur de la structure de conditionnement (100), une extrémité de la borne d'alimentation (103e) située à l'intérieur de la structure de conditionnement (100) est située sur une première couche de liaison (102) autre que la première couche de liaison (102) correspondant à la puce (103a) et la première couche de liaison (102) correspondant à la borne de signal (103d), la première couche de liaison (102) comprend un premier matériau de liaison (102b) et une première partie de support (102a) qui est fixée sur la première surface conductrice du premier substrat (101), et la première couche de liaison (102) correspondant à la puce (103a) et la première couche de liaison (102) correspondant à la borne d'alimentation (103e) correspondent à une même zone conductrice dans la première surface conductrice du premier substrat (101) ; et/ou la borne d'alimentation (103e) est située sur une deuxième couche de liaison (104) autre qu'une deuxième couche de liaison (104) correspondant à la puce (103a), la deuxième couche de liaison (104) comprend un deuxième matériau de liaison (104b) et une deuxième partie de support (104a) qui est fixée sur la première surface conductrice du second substrat (105), et la deuxième couche de liaison (104) correspondant à la puce (103a) et une deuxième couche de liaison (104) correspondant à la borne d'alimentation (103e) correspondent à une même zone conductrice dans la première surface conductrice du second substrat (105).

2. Structure de conditionnement (100) selon la revendication 1, dans laquelle la deuxième couche de liaison (104) comprend un deuxième matériau de liaison (104b) et au moins une deuxième partie de support (104a), une hauteur de l'au moins une deuxième partie de support (104a) est identique à une épaisseur de la deuxième couche de liaison (104), et un point de fusion de l'au moins une deuxième partie de support (104a) est supérieur à une température maximale à laquelle la deuxième couche de liaison (104) est formée, de sorte que la deuxième couche de liaison (104) a une surface plane et une épaisseur uniforme.

3. Structure de conditionnement (100) selon la revendication 2, dans laquelle l'au moins une deuxième partie de support (104a) est fixée sur la seconde surface de liaison de l'élément électronique (103) ou sur la première surface conductrice du second substrat (105).

4. Structure de conditionnement (100) selon l'une quelconque des revendications 1 à 3, dans laquelle la structure de conditionnement (100) comprend en outre un matériau de conditionnement en plastique (106) ; et le premier substrat (101), la première couche de liaison (102), une partie de l'élément électronique (103), la deuxième couche de liaison (104) et le second substrat (105) sont tous disposés dans le matériau de conditionnement en plastique (106).

5. Structure de conditionnement (100) selon l'une quelconque des revendications 1 à 4, dans laquelle
l'au moins une première partie de support (102a) est fixée sur la première surface de liaison de l'élément électronique (103) ou sur la première surface conductrice du premier substrat (101).

6. Structure de conditionnement (100) selon la revendication 1, dans laquelle l'élément électronique (103) comprend en outre un capteur (107) ; et
les deux extrémités du capteur (107) sont situées séparément sur les premières couches de liaison (102) autres que la première couche de liaison (102) correspondant à la puce (103a), la première couche de liaison (102) correspondant à la borne de signal (103d) et la première couche de liaison (102) correspondant à la borne d'alimentation (103e), la première couche de liaison (102) comprend un premier matériau de liaison (102b) et une première partie de support qui est fixée sur la première surface conductrice du premier substrat (101), et la première couche de liaison (102) correspondant à la puce (103a) et les deux premières couches de liaison (102) correspondant au capteur (107) correspondent à des zones conductrices différentes dans la première surface conductrice du premier substrat (101) ; et/ou une extrémité du capteur (107) est située sur une première couche de liaison (102) autre que la première couche de liaison (102) correspondant à la puce (103a), la première couche de liaison (102) correspondant à la borne de signal (103d), et la première couche de liaison (102) correspondant à la borne d'alimentation (103e), la première couche de liaison (102) comprend un premier matériau de liaison (102b) et une première partie de support qui est fixée sur la première surface conductrice du premier substrat (101), l'autre extrémité du capteur (107) s'étend de l'intérieur de la structure de conditionnement à l'extérieur de la structure de conditionnement par le biais d'un fil de transmission, et la première couche de liaison (102) correspondant à la puce (103a) et la première couche de liaison (102) correspondant au capteur (107) correspondent à des zones conductrices différentes dans la première surface conductrice du premier substrat (101).

7. Structure de conditionnement (100) selon l'une quelconque des revendications 1 à 6, dans laquelle la structure de conditionnement (100) comprend en outre une première partie de dissipation thermique (108) et une quatrième couche de liaison (109) ; la quatrième couche de liaison (109) est située entre une seconde surface conductrice du premier substrat (101) et la première partie de dissipation thermique (108), la seconde surface conductrice du premier substrat (101) est exposée à l'extérieur de la structure de conditionnement (100), et la quatrième couche de liaison (109) est configurée pour mettre en oeuvre une liaison entre le premier substrat (101) et la première partie de dissipation thermique (108) ; et la quatrième couche de liaison (109) comprend un quatrième matériau de liaison (109b) et au moins une quatrième partie de support (109a), une hauteur de la quatrième partie de support (109a) est identique à l'épaisseur de la quatrième couche de liaison (109), et un point de fusion de la quatrième partie de support (109a) est supérieur à la température maximale à laquelle la quatrième couche de liaison (109) est formée, de sorte que la quatrième couche de liaison (109) a une surface plane et une épaisseur uniforme.

8. Structure de conditionnement (100) selon la revendication 7, dans laquelle l'au moins une quatrième partie de support (109a) est fixée sur la seconde surface conductrice du premier substrat (101) ou sur une face de la première partie de dissipation thermique (108) qui est proche du premier substrat (101).

9. Structure de conditionnement (100) selon l'une quelconque des revendications 1 à 8, dans laquelle la structure de conditionnement comprend en outre une deuxième partie de dissipation thermique (110) et une cinquième couche de liaison (111) ; la cinquième couche de liaison (111) est située entre une seconde surface conductrice du second substrat (105) et la deuxième partie de dissipation thermique (110), la seconde surface conductrice du second substrat (105) est exposée à l'extérieur de la structure de conditionnement (100), et la cinquième couche de liaison (111) est configurée pour mettre en oeuvre une liaison entre le second substrat (105) et la deuxième partie de dissipation thermique (110) ; et la cinquième couche de liaison (111) comprend un cinquième matériau de liaison (111b) et au moins une cinquième partie de support (111a), une hauteur de la cinquième partie de support (111a) est identique à l'épaisseur de la cinquième couche de liaison (111), et un point de fusion de la cinquième partie de support (111a) est supérieur à la température maximale à laquelle la cinquième couche de liaison (111) est formée, de sorte que la cinquième couche de liaison (111) a une surface plane et une épaisseur uniforme.

10. Structure de conditionnement (100) selon la revendication 9, dans laquelle l'au moins une cinquième partie de support (111a) est fixée sur la seconde surface conductrice du second substrat (105) ou sur un côté de la deuxième partie de dissipation thermique (110) qui est proche du second substrat (105).

11. Véhicule électrique (1), comprenant une batterie d'alimentation (11), une unité de commande de moteur, MCU (12), et Q moteurs (13), dans lequel Q est un nombre entier positif ;
l'unité de commande du moteur, MCU (12) comprend 3R structures de conditionnement (100) selon l'une quelconque des revendications 1 à 10, R est un nombre entier positif, la batterie d'alimentation (11) fournit une première énergie électrique pour chaque structure de conditionnement (100), et chaque moteur (13) est relié de manière correspondante à au moins trois structures de conditionnement (100) ; et
pour l'une quelconque des 3R structures de conditionnement (100), l'unité de commande du moteur, MCU (12) est configurée pour : commander la structure de conditionnement (100) afin de convertir la première énergie électrique en une seconde énergie électrique requise par un moteur (13) relié de manière correspondante à la structure de conditionnement (100), et commander la structure de conditionnement (100) afin de transmettre la seconde énergie électrique au moteur (13) relié de manière correspondante à la structure de conditionnement (100).
